(19) Europäisches Patentamt
European Patent Office
Office européen des brevets

(11) **EP 1 362 931 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**21.08.2019 Patentblatt 2019/34**

(45) Hinweis auf die Patenterteilung:
**20.07.2005 Patentblatt 2005/29**

(21) Anmeldenummer: **03014612.0**

(22) Anmeldetag: **27.12.2000**

(51) Int Cl.:
*C23C 28/04* (2006.01)     *C23C 28/00* (2006.01)
*C23C 16/26* (2006.01)     *C23C 16/02* (2006.01)
*F16C 33/04* (2006.01)     *H01J 37/32* (2006.01)

(54) **Verfahren und Vorrichtung zur Herstellung eines DLC-Schichtsystems**

Method and apparatus for fabrication of a DLC layer system

Procédé et dispositif pour la fabrication d'un système de couches de DLC

(84) Benannte Vertragsstaaten:
**AT BE CH CY DE DK ES FI FR GB GR IE IT LI LU MC NL PT SE TR**

(30) Priorität: **12.04.2000 DE 10018143**

(43) Veröffentlichungstag der Anmeldung:
**19.11.2003 Patentblatt 2003/47**

(62) Dokumentnummer(n) der früheren Anmeldung(en) nach Art. 76 EPÜ:
**00993868.9 / 1 272 683**

(73) Patentinhaber: **Oerlikon Surface Solutions AG, Trübbach**
**9477 Trübbach (CH)**

(72) Erfinder:
- **Massler, Orlaw**
  **6800 Feldkirch (AT)**
- **Pedrazzini, Mauro**
  **9492 Eschen (LI)**
- **Wohlrab, Christian**
  **6800 Feldkirch (AT)**
- **Eberle, Hubert**
  **9496 Balzers (LI)**
- **Grischke, Martin**
  **9494 Schaan (LI)**
- **Michler, Thorsten**
  **55128 Mainz (DE)**

(74) Vertreter: **Hecht, Jan-David**
**Patentanwaltskanzlei Dr. Hecht**
**Ranstädter Steinweg 28**
**04109 Leipzig (DE)**

(56) Entgegenhaltungen:

| EP-A- 0 577 246 | EP-A- 0 600 533 |
|---|---|
| EP-A1- 0 306 612 | EP-A1- 0 413 853 |
| EP-A1- 0 577 246 | EP-A1- 0 600 533 |
| EP-A1- 0 962 550 | EP-A2- 0 413 291 |
| WO-A1-90/02216 | WO-A1-95/04368 |
| WO-A1-97/34315 | WO-A2-99/14390 |
| WO-A2-99/27893 | DD-A1- 133 688 |
| DE-A1- 4 126 852 | DE-A1- 19 635 736 |
| DE-A1- 19 740 793 | DE-A1- 19 960 092 |
| DE-C- 19 513 614 | DE-T2- 3 876 120 |
| FR-A- 2 596 775 | US-A- 4 992 153 |
| US-A- 4 992 153 | US-A- 5 556 519 |
| US-A- 5 629 086 | US-A- 5 629 086 |
| US-A- 5 695 832 | US-A- 5 709 784 |
| US-A- 5 712 000 | US-A- 5 750 210 |
| US-A- 5 750 210 | |

- **DENG J ET AL: "DLC multilayer coatings for wear protection" DIAMOND AND RELATED MATERIALS, ELSEVIER SCIENCE PUBLISHERS, AMSTERDAM, NL, Bd. 4, Nr. 7, 15. Mai 1995 (1995-05-15), Seiten 936-943, XP004066766 ISSN: 0925-9635**
- **VOEVODIN A A ET AL: "Design of a Ti/TiC/DLC functionally gradient coating based on studies of structural transitions in Ti-C thin films" THIN SOLID FILMS, ELSEVIER-SEQUOIA S.A. LAUSANNE, CH, Bd. 298, Nr. 1-2, 20. April 1997 (1997-04-20), Seiten 107-115, XP004125924 ISSN: 0040-6090**
- **DATABASE WPI Section Ch, Week 199831 Derwent Publications Ltd., London, GB; Class M21, AN 1998-355840 XP002251300 & JP 10 137861 A (SKY ALUMINIUM CO LTD), 26. Mai 1998 (1998-05-26)**

- LI K Y ET AL: "Mechanical and tribological properties of diamond-like carbon films prepared on steel by ECR-CVD process" DIAMOND AND RELATED MATERIALS, ELSEVIER SCIENCE PUBLISHERS, AMSTERDAM, NL, Bd. 10, Nr. 9-10, September 2001 (2001-09), Seiten 1855-1861, XP004321136 ISSN: 0925-9635
- HEINKE W ET AL: "Evaluation of PVD nitride coatings, using impact, scratch and Rockwell-C adhesion tests" 22ND INTERNATIONAL CONFERENCE ON METALLURGICAL COATING AND THIN FILMS, SAN DIEGO, CA, USA, 24-28 APRIL 1995, Bd. 270, Nr. 1-2, Seiten 431-438, XP002251299 Thin Solid Films, 1 Dec. 1995, Elsevier, Switzerland ISSN: 0040-6090
- HAEFER, R.: Oberflächen- und Dünnsicht-Technologogie, vol. 1, 1987, Springer Verlag, Berlin
- HAMMER HAMMER: "Physikalische Formeln und Tabellen", 1988, J. Lindauer Verlag, München
- VDI 3824, Blatt 4, August 2001
- GRILL, A.: "Diamond-like Carbon: state of the art", Diamond and Related Materials, vol. 8, 1999, pages 428-434,
- Lifshitz, Y.: "Diamond-like Carbon: present status", Diamond and Related Materials, vol. 8, 1999, pages 1659-1676,
- GRISCHKE, M.: "Application-oriented modifications of deposition processes for diamond-like-carbon-based coatings", Surface and Coatings Technology, vol. 74-75, 1995, pages 739-745,
- VDI 3198, August 1992
- TAUBE, K.: "Carbon-based coatings for dry sheet-metal working", Surface and Coatings Technology, vol. 98, 1998, pages 976-984,
- DONNET, C.: "Recent progress on the tribology of doped diamond-like and carbon alloy coatings: a review", Surface and coating technology, vol. 100, no. 101, 1998, pages 180-186,
- MICHLER, T. ET AL: "Mechanical properties of DLC films prepared by bipolar pulsed DC PACVD", Diamond and Related Materials, vol. 7, 1998, pages 1333-1337,
- MICHLER, T. ET AL: "Continuously deposited duplex coatings consisting of plasma nitriding and a-C:H:Si deposition", Surface and Coatings Technology, vol. 111, 1999, pages 41-45,
- VARMA, A. ET AL: "Tribological behaviours of Si-DLC Coatings", SURFACE ENGINEERING, vol. 15, no. 4, 1999, pages 301-306,
- MICHLER, T. ET AL: "DLC films deposited by bipolar pulsed DC PACVD", Diamond and Related Materials, vol. 7, 1998, pages 459-462,
- VOEVODIN, A. ET AL: "Design of a Ti/TiC/DLC functionally gradient coating based on studies of structural transitions in Ti-C thin films", THIN SOLID FILMS, ELSEVIER-SEQUOIA S.A., vol. 298, no. 1-2, April 1997 (1997-04), pages 107-115, XP004125924,
- DATABASE DATABASE WPI Section Ch, Week 199831; Thomson Scientific: "Class M21", XP002251300, Database accession no. 1998-355840 & JP H10 137861 A
- LI, K. ET AL: "Mechanical and tribological properties of diamond-like carbon films prepared on steel by ECR-CVD process", DIAMOND AND RELATED MATERI, vol. 10, no. 9-10, 1 September 2001 (2001-09-01), pages 1855-1861, XP004321136,
- HEINKE, W. ET AL: "Evaluation of PVD nitride coatings, using impact, scratch and Rockwell-C adhesion tests", Thin Solid Films, vol. 270, no. 1-2, 24 May 1995 (1995-05-24), pages 431-438, XP004001734,
- KRUMPIEGL, T.: "Vermeidung von Schmierstoffen in Gelenklagern durch PVD-Beschichtungen", Abschlussbericht BMBF, Förderkennzeichen: 13N6220, June 1997 (1997-06),
- DIN EN ISO 4516, Oktober 2002, Ersatz für DIN 4516, 1988-07, Mikrohärteprüfung nach Vickers und Knoop
- Fraunhofer Institut, Produktnemenverzeichnis - Kohlenstoffschichten, 2006
- ORAL, B. et al: "Adhesion and structural changes of multilayered and multi-doped a-C:H films during annealing", Diamond and Related Materials, vol. 5, 1996, pages 932-937,
- Grischke, . et al: "Variation of the wettability of DLC-coatings by network modification using silicon and oxygen", Diamond and Related Materials, vol. 7, no. 2-5, February 1998 (1998-02), pages 454-458, XP004115084,
- DIMIGEN, H.: "Neue Ansätze zur wirtschaftlichen Fertigung optimierter Schichtsysteme", GALVANOTECHNIK, vol. 5, no. 89, 1998,
- HIEKE, A.: "Diamantähnliche Kohlenstoffschichten (DLC) - verschleissfest und reibarm", Mat.-wiss. und Werkstofftechnik, vol. 31, 2000, pages 625-628,
- Michler T et al: "DLC films deposited by bipolar pulsed DC PACVD", Diamond and Related Materials, vol. 7, no. 2-5, 1 February 1998 (1998-02-01), pages 459-462, XP004115085,
- RICE, P. ET AL: "Correlation of Nanoindention and Conventional Mechanical Porperty Measurements", Proceedings MSR - Fall meeting 2000 Fundamentals of Nanotribology, vol. 649, no. Q7 - 11 ,
- ASTM Härte-Tabelle, Internet Ausdrück
- MÜLLER, U. et al: "Pores in hydrogenated amorpheus carbon films on stainless steel", Surface and Coatings Technology, vol. 71, 1995, pages 233-238,
- MÜLLER, U. et al: "Ultrahartstoff Beschichtungen aus Kohlenstoff", Oberflächen Werkstoffe, no. 4, 1997,

- Taube, K et al: "Improvement of carbon-based coatings for use in the cold forming of non-ferrous metals", Surface and Coatings Technology, vol. 68-69, 1 December 1994 (1994-12-01), pages 662-668, XP024546374,
- HOFMANN, D. et al: "Plasma-booster-assisted hydrogenated W-C coatings", Surface and Coatings Technology, vol. 73, 1995, pages 137-141,
- Datenblatt Balzers BAS 450 PM
- Expert statement of Prof. A. Matthews, University of Sheffield
- Unbalanced Magnetrons: Their Impact on Modern PVD Hard Coating Equipment
- NEUVILLE, S. ET AL: "Hard Carbon coatings: the way forward", September 1997 (1997-09)
- Adhesion Test Report, Ionbond
- VOEVODIN, A. ET AL: WEAR, vol. 203-204, 1997, pages 515-527,
- Notarielle Urkunde, Dr. Oyda
- Analysis Report, Philips Innovation Services
- RONKAINEN, H.: "Improvement of a-C:H film adhesion by intermediate layers and sputter cleaning procedures on stainless steel; alumina and cemented carbide", Surface Coating and Technology, vol. 90, 1997, pages 190-196,

**Beschreibung**

Die vorliegende Erfindung betrifft ein Verfahren nach Patenanspruch 1. Bevorzugte Ausführungen der Erfindung werden in den Unteransprüchen 2 bis 17 offengelegt. Trotz der herausragenden Eigenschaften von diamantähnlichem Kohlenstoffschichten (DLC-Schichten), wie hoher Härte und ausgezeichneter Gleiteigenschaften, und einer langjährigen weltweiten Forschungtätigkeit, konnten bis heute noch keine reinen DLC-Schichten hergestellt werden, die auch bei grösseren Schichtdicken (> 1 $\mu$m) eine für den industriellen Einsatz in typischen Verschleissschutzanwendungen ausreichende Schichthaftung zeigen und eine ausreichende Leitfähigkeit aufweisen, um auf die mit vielen produktionstechnischen Nachteilen behafteten Hochfrequenz (HF)-Verfahren zur Herstellung verzichten zu können.

Als typische Verschleissschutzanwendungen seien hier einerseits Anwendungen im Maschinenbaubereich, wie Schutz vor Gleitverschleiss, Pitting, Kaltverschweissung etc., insbesondere auf Bauteilen mit gegeneinander bewegten Flächen, wie beispielsweise Zahnrädern, Pumpen- und Tassenstössel, Kolbenringe, Injektorennadeln, komplette Lagersätze oder deren einzelne Bestandteile u.v.a. genannt, sowie andererseits Anwendungen im Bereich der Materialbearbeitung zum Schutz der eingesetzten Werkzeuge zur spanenden oder umformenden Bearbeitung sowie bei Spritzgussformen.

Neben der vielseitigen Anwendungsmöglichkeiten im Verschleissschutzbereich sei hier noch ausdrücklich der Korrosionsschutz als weiterer vielversprechender Anwendungsbereich von derartigen DLC-Schichten genannt.

Reine DLC-Schichten können heute auf Grund der hohen Eigenspannungen und der damit verbundenen problematischen Haftung, insbesondere bei hochbeanspruchten Flächen im Verschleissschutz nur mit geringen, für viele Anwendungen unzureichenden Schichtdicken abgeschieden werden oder müssen durch zusätzlichen Einbau von Fremdatomen, wie beispielsweise Silizium, verschiedenen Metallen und Fluor in ihren Eigenschaften verändert werden. Allerdings war die damit erreichte Verringerung der Schichteigenspannungen und Verbesserung der Haftung immer mit einem deutlichem Härteverlust verbunden, der sich gerade im Verschleissschutzbereich oftmals negativ auf die Lebensdauer des jeweils beschichteten Gegenstands auswirken kann.

Ein zusätzliches Aufbringen von Einlaufschichten, die beispielsweise graphitischen Kohlenstoff und/oder eine Mischung aus Metall bzw. Metallkarbid und Kohlenstoff enthalten, konnte daher nicht in Betracht gezogen werden, da einerseits durch die zum Erreichen des Einlaufeffekts notwendige Mindestschichtdicke weitere schädliche Schichteigenspannungen aufgebaut wurden und andererseits die Haftung auf reinen Kohlenstoffschichten problematisch war. Erst solche Schichten können aber durch die Kombination der sehr harten Kohlenstoffschicht, bzw. Diamantschicht mit der darauf abgeschiedenen Gleit- bzw. Einlaufschicht den zunehmenden Anforderungen für Bauteile, wie sie beispielsweise für einzelne Komponenten im modernen Motorenbau gefordert werden entsprechen.

Bei heute üblichen plasmagestützten Verfahren zur Herstellung von DLC-Schichten werden auf Grund des hohen elektrischen Widerstandes harter DLC-Schichten häufig, um störende Aufladungen während der Beschichtung zu vermeiden, Prozesse mit einem HF-Bias bzw. Plasma (als HF = Hochfrequenz werden im folgenden alle Frequenzen > 10 MHz verstanden), insbesondere mit der Industriefrequenz 13,56 MHz, angewandt. Die bekannten Nachteile dieser Technik, sind schwer beherrschbare Störungen elektronisch empfindlicher Prozesssteuerungseinheiten (HF-Rückkopplungen, Senderwirkung, ...) ein erhöhter Aufwand um HF-Ueberschläge zu vermeiden, Antennenwirkung der zu beschichtenden Substrate und ein damit verbundener relativ grosser Mindestabstand zwischen dem Beschichtungsgut, der eine optimale Raum- und Flächennutzung in der Beschichtungskammer verhindert. So ist bei HF-Verfahren genauestens darauf zu achten, dass es, beispielsweise durch eine zu hohe Beladungsdichte, falsche Substrat / Halterungsabstände etc., nicht zu einer Überlappung von Dunkelräumen kommt, wodurch schädliche Nebenplasmen entstehen. Derartige Nebenplasmen bilden einerseits Energiesenken und belasten so zusätzlich die Plasmageneratoren, andererseits kommt es durch derartige lokale Plasmakonzentrationen häufig zu einer thermischen Überhitzung der Substrate und unerwünschter Graphitisierung der Schicht.

Auf Grund der bei HF-Prozessen berechneten exponentiellen Abhängigkeit der Substratspannung von der Substratoberfläche

$$US/UE=CE/CS=(AE/AS)4$$

wobei U für die Spannung, C für die Kapazität, A für die Oberfläche und die Indizes S für Substrat bzw. E für die Gegenelektrode stehen, kommt es bei steigender Substratoberfläche AS zu einem starken Abfall der Substratspannung US begleitet von einem starken Anstieg der Verlustleistung. Daher kann abhängig von der Leistungsfähigkeit der eingesetzten Generatoren nur eine bestimmte Maximalfläche beschichtet werden. Anderenfalls kann entweder nicht genügend Leistung in das System eingebracht bzw. die Potentialdifferenz (Substratspannung) nicht ausreichend hoch eingestellt werden, um den für gut haftende dichte Schichten notwendigen Ionplatingeffekt zu erzielen.

Ferner ist auf der Anlagenseite bei HF-Prozessen üblicherweise zusätzlicher apparativer Aufwand notwendig, um Generator- und Plasmaimpedanzen durch elektrische Netzwerke, wie beispielsweise eine sogenannte Matchbox, während des Prozesses dynamisch aneinander anzupassen.

Im folgenden werden kurz verschiedene aus dem Stand der Technik bekannte Verfahren bzw. Schichtsysteme angeführt.

Die EP 87 836 offenbart ein DLC-Schichtsystem mit einem 0,1 - 49,1%igen Anteil metallischer Komponenten, welches beispielsweise mittels kathodischem Sputtern abgeschieden wird.

Die DE 43 43.354 A1 beschreibt ein Verfahren zur Herstellung eines mehrlagigen Tihaltigen Schichtsystems mit einer Hartstoffschicht aus Titannitriden Titankarbiden und Titanboriden sowie einer reibmindernden C-haltigen Oberflächenschicht, wobei der Ti- und N-Anteil in Richtung der Oberfläche fortschreitend verringert wird.

Einen gepulsten Plasmastrahl verwendet das in der US 5 078 848 beschriebene Verfahren zur Herstellung von DLC-Schichten. Auf Grund der gerichteten Teilchenstrahlung aus einer Quelle mit geringem Austrittsquerschnitt eignen sich aber solche Verfahren nur bedingt zur gleichmässigen Beschichtung grösserer Flächen.

Verschiedene CVD-Verfahren bzw. mit solchen Verfahren hergestellte SiDLC/DLC Mischschichten werden in den folgenden Dokumenten beschrieben:

Die EP-A-651 069 beschreibt ein reibminderndes Verschleissschutzsystem aus 2 - 5000 alternierenden DLC und SiDLC-Schichten. Ein Verfahren zur Abscheidung von a-DLC-Schichten mit einer Si-Zwischenschicht und daran anschliessender a-SiC:H-Uebergangszone zur Verbesserung der Haftung wird in der EP-A-600 533 beschrieben. Auch in der EP-A-885 983 und der EP-A-856 592 werden verschiedene Verfahren zur Herstellung solcher Schichten beschrieben. In der EP-A-885 983 beispielsweise wird das Plasma durch ein DC-beheiztes Filament erzeugt und die Substrate mit negativer Gleichspannung oder MF zwischen 20 - 10.000 kHz beaufschlagt (als MF = Mittelfrequenz wird im folgenden der Frequenzbereich zwischen 1 und 10.000 kHz verstanden).

Die US 4 728 529 beschreibt eine Methode zur Abscheidung von DLC unter Anwendung eines HF-Plasmas, bei der die Schichtbildung in einem Druckbereich zwischen 103 und 1 mbar aus einem sauerstofffreien Kohlenwasserstoffplasma, dem bei Bedarf Edelgas oder Wasserstoff beigemischt wird, erfolgt.

Der in der DE-C-195 13 614 beschriebene Prozess verwendet eine bipolare Substratspannung mit einer kürzeren positiven Pulsdauer in einem Druckbereich zwischen 50-1000 Pa. Damit werden Schichten im Bereich von 10 nm bis 10 $\mu$m und einer Härte zwischen 15 - 40 GPa abgeschieden.

Ein CVD-Verfahren mit unabhängig vom Beschichtungsplasma erzeugter Substratspannung wird in der DE-A-198 26 259 beschrieben, wobei bevorzugt bipolare, jedoch auch andere periodische veränderte Substratspannungen angelegt werden. Dies bedarf jedoch einer relativ aufwendigen, da in zweifacher Ausführung vorzusehenden, elektrischen Versorgungseinheit zur Durchführung des Verfahrens.

Weiters sind Verfahren aus einer Kombination traditioneller Hartstoffschichten mit einer kohlenstoffreichen Deckschicht mit günstigen Gleiteigenschaften schon länger bekannt.

Beispielsweise offenbart US 5,707,748 eine Schichtkombinationen aus metallhaltigen Hartstoffschichten (TiN, TiAIVN, WC) und einer weniger harten Metallkarbidschicht mit zunehmendem Gehalt an graphitisch, d.h. in sp$^2$ Hybridisierung, gebundenem Kohlenstoff. Durch die guten Gleiteigenschaften von Metall/- bzw. Metallkarbid/Kohlenstoffschichten (MeC/C) werden diese bevorzugt in Tribosystemen eingesetzt, wo neben dem Schutz des beschichteten Teils eine Verringerung der Reibungskräfte und/oder ein Schutz des Gegenkörpers bewirkt werden sollen. Besonders wirkungsvoll haben sich diesbezüglich MeC/C-Schichten mit einem hohen C-Anteil erwiese, bei denen durch die weiche Deckschicht einerseits ein Einlaufeffekt, andererseits durch Übertrag von C-Partikeln ein Schmiereffekt für das ganze Tribosystem erreicht werden kann. Ähnliche Schichtkombinationen mit einer die Haftung verbessernden metallischen Zwischenschicht zwischen der Hartstoffschicht und der graphitischen Kohlenstoff enthaltenden Metall- bzw. MeC-Schicht werden in WO 99-55929 beschrieben.

Der Artikel "DLC multilayer coatings for wear protection" von Deng J. et al., Diamond and Related Materials, Elsevier Science Publishers, Amsterdam, NL, Bd. 4, Nr. 7, 15. Mai 1995, S. 936- 943 offenbart eine DLC Multilayer-Beschichtung als Verschleißschutz. Die DLC- Schicht ist auf einer Ti- Haftschicht und einer Multilayer- Übergangsschicht aus einer Abfolge von TiN, TiCN und TiC aufgebracht. Die Übergangsschicht ist eine vielschichtige Gradientenschicht, in der der Stickstoffgehalt abnimmt und der Kohlenstoffgehalt zur DLC- Schicht hin zunimmt.

Die Druckschrift FR 2 596 775 zeigt einen Prozess zur Herstellung eines Schichtsystems sowie das Schichtsystem selbst. Die spezielle Anlagengeometrie zielt auf eine möglichst hohe Ionisation des Prozessgases bzw. des Metalldampfes ab. Eine dritte Elektrode ist vorgesehen, um ein Abdriften von Elektronen an die Wände zu verhindern. Eine Elektronenkanone ist im unteren Bereich des Gehäuses angeordnet.

Die US 5,709,784 betrifft eine Vorrichtung zum Beschichten mittels einer Niedervolt- Bogenentladung. Die Vorrichtung umfasst, neben den üblichen Komponenten, insbesondere auch eine Einrichtung zum Anlegen einer Substratbiasspannung an das Substrat, sowie Helmholtz- Spulen zur Erzeugung eines Magnetfelds. Mittels dieser Anlage kann ein Niedervoltbogenprozess durchgeführt werden. Neben einer Kathode und einer Anode ist eine zusätzliche Spannungsquelle zur Erzeugung einer positiven Gleichspannung an der Anode vorgesehen.

Entsprechend ist es die Aufgabe der vorliegenden Erfindung ein Verfahren zur Herstellung relativ dicker DLC-Schichtsysteme mit hoher Härte und ausgezeichneter Haftfestigkeit zur Verfügung zu stellen, die ausserdem noch eine genügend hohe Leitfähigkeit besitzen, um ohne HF-Bias abgeschieden werden zu können, wobei das Verfahren und die dazu verwendete Vorrichtung keinen grossen Aufwand erfordern und eine hohe Effektivität für den industriellen Einsatz aufweisen.

Diese Aufgabe wird gelöst durch das Verfahren nach Merkmalssatz 1. Vorteilhafte Ausgestaltungen sind Gegenstand der Untermerkmalssätze.

Aufgabe der vorliegenden Erfindung ist es somit insbesondere ein Verfahren zur Herstellung einer DLC- bzw. einer Diamantschicht mit einer ausgezeichneten Haftfestigkeit und einem hohen Verschleisswiderstand zur Verfügung zu stellen, die gegenüber herkömmlichen DLC- bzw. Diamantschichten verbesserte Gleiteigenschaften und falls erwünscht Einlaufeigenschaften aufweist. Eine solche DLC-Gleitschichtsystem kann für den Verschleissschutz, den Korrosionsschutz und zur Verbesserung der Gleiteigenschaften von Vorteil sein, insbesonders dann, wenn bis jetzt schwer in einem Schichtsystem zu verwirklichende Eigenschaften gleichzeitig erwünscht sind.

Dies wird gemäß dem unabhängigen Anspruch gelöst.


**SCHICHTSYSTEM**

Ein mit dem erfindungsgemäßen Verfahren hergestelltes DLC-Schichtsystem wird durch Herstellen einer Schicht mit folgendem Schichtaufbau erreicht.

Direkt auf dem Substrat befindet sich eine Haftschicht mit mindestens einem Element aus der Gruppe der Elemente der IV, V und VI Nebengruppe sowie Si. Bevorzugt wird eine Haftschicht aus den Elementen Cr oder Ti verwendet, die sich für diesen Zweck als besonders geeignet erwiesen haben.

Daran schliesst sich eine Uebergansschicht an, die vorzugsweise als Gradientenschicht ausgebildet ist, in deren Verlauf senkrecht zur Substratoberfläche der Metallgehalt ab - und der C-Gehalt zunimmt.

Die Uebergangsschicht umfasst im wesentlichen Kohlenstoff und mindestens ein Element aus der Gruppe der Elemente, die die Haftschicht bilden. Zusätzlich kann bei einer bevorzugten Ausführungsform Wasserstoff enthalten sein. Darüber hinaus beinhalten sowohl die Uebergangsschicht als auch die Haftschicht unvermeidbare Verunreinigungen, wie sie beispielsweise durch in die Schicht eingebaute Atome aus der umgebenden Atmosphäre gegeben sind, beispielsweise die bei der Herstellung verwendeten Edelgase, wie Argon oder Xenon.

Bei der Ausbildung der Uebergangsschicht in Form einer Gradientenschicht kann der Zuwachs des Kohlenstoffs in Richtung der Deckschicht durch Zunahme gegebenenfalls unterschiedlicher karbidischer Phasen, durch Zunahme des freien Kohlenstoffs, bzw. durch eine Mischung derartiger Phasen mit der metallischen Phase der Uebergangsschicht erfolgen. Die Dicke der Gradienten- bzw. Uebergangsschicht kann dabei, wie dem Fachmann bekannt, durch Einstellung geeigneter Prozessrampen eingestellt werden. Die Zunahme des C-Gehalt bzw. Abnahme der metallischen Phase kann kontinuierlich oder stufenweise erfolgen, ferner kann zumindest in einem Teil der Uebergangsschicht auch eine Abfolge metallreicher und C-reicher Einzelschichten zum weiteren Abbau von Schichtspannungen vorgesehen werden. Durch die erwähnten Ausbildungen der Gradientenschicht werden die Materialeigenschaften (beispielsweise E-Modul, Struktur etc.) der Haft- und der abschliessenden DLC-Schicht im wesentlichen kontinuierlich aneinander angepasst und damit der Gefahr der Rissbildung entlang einer sonst auftretenden Metall bzw. Si /DLC-Grenzfläche entgegengewirkt.

Den Abschluss des Schichtpakets bildet eine im wesentlichen ausschliesslich aus Kohlenstoff und vorzugsweise Wasserstoff bestehende Schicht, mit einer im Vergleich zur Haft- und Uebergansschicht grösseren Schichtdicke. Zusätzlich zum Kohlenstoff und Wasserstoff können auch hier Edelgase, wie Argon oder Xenon vorkommen. Wesentlich ist hier jedoch, dass auf zusätzliche metallische Elemente oder Silizium vollständig verzichtet wird.

Die Härte des gesamten DLC-Schichtsystems ist auf einen Wert grösser 15 GPa, bevorzugt grösser/gleich 20 GPa eingestellt und eine Haftfestigkeit besser oder gleich HF 3, bevorzugt besser oder gleich HF 2, insbesondere gleich HF 1 nach VDI 3824 Blatt 4 wird erreicht. Die Härte wird hierbei über die Knoop Härtemessung mit o,1 N Last, d.h. HK0,1 entsprechen. Der Oberflächenwiderstand der DLC-Schicht liegt zwischen $\delta = 10\text{-}6\Omega$ und $\delta = 5M\Omega$, bevorzugt zwischen $1\Omega$ und 500 k$\Omega$, bei einem Elektrodenabstand von 20 mm. Gleichzeitig zeichnet sich die vorliegende DLC-Schicht durch die für DLC typische niedrige Reibkoeffizienten, bevorzugt $\mu \leq 0.3$ im Stift / Scheibetest, aus.

Die Schichtdicken sind insgesamt > 1 $\mu$m, vorzugsweise > 2 $\mu$m, wobei die Haftschicht und die Uebergangsschicht vorzugsweise Schichtdicken von 0.05 $\mu$m bis 1,5 $\mu$m, insbesondere von 0,1 $\mu$m bis 0,8 $\mu$m aufweisen, während die Deckschicht vorzugsweise eine Dicke von 0,5 $\mu$m bis 20 $\mu$m, insbesondere 1 $\mu$m bis 10 $\mu$m hat.

Der H-Gehalt ist in der Deckschicht vorzugsweise 5 bis 30 Atom%, insbesondere 10 - 20 Atom%.

In REM-Aufnahmen zeigen solchermaßen abgeschiedene DLC-Schichtsysteme Bruchfläche, die im Gegensatz zu herkömmlichen DLC-Schichten, keine glasigamorphe sondern eine feinkörnige Struktur aufweisen, wobei die Korngrösse bevorzugt $\leq$ 300 nm, insbesondere $\leq$ 100 nm beträgt.

In tribologischen Tests unter hoher Belastung zeigt die Beschichtung eine vielfache Lebensdauer gegenüber anderen DLC-Schichten, wie beispielsweise Metallkohlenstoff-, insbesonders WC/C-Schichten. So konnte auf einer mit einer DLC-Schicht versehenen Einspritzdüse für Verbrennungsmotoren im Test nach 1000h nur ein geringfügiger Verschleiss festgestellt werden, wohingegen im selben Test eine mit WC/C beschichtete Düse bereits nach 10h auf Grund eines hohen Oberflächenverschleisses bis in den Grundwerkstoff ausfiel.

Die Schichtrauhigkeit der entsprechenden DLC-Schicht hat vorzugsweise einen Wert von Ra=0.01-0.04; wobei Rz nach DIN gemessen < 0.8 bevorzugt < 0.5 ist.

Die Vorteile eines entsprechenden DLC-Schichtsystems mit obigen Eigenschaften liegen in der erstmals gelungenen Kombination von grossen Schichtdicken mit ausgezeichneter Haftfestigkeit, die noch eine ausreichende Leitfähigkeit aufweisen, um eine verhältnismässig einfache Prozessführung in der industriellen Produktion zu ermöglichen.

Trotz der hohen Härte von > 15 GPa, bevorzugt $\geq$ 20 GPa zeigt die Schicht auf Grund ihrer Struktur und der erfindungsgemässen Verfahrensschritte eine deutlich verbesserte Haftung. Herkömmliche Schichtsysteme benötigen hier eine Dotierung in der Funktionsschicht (DLC), um die Schichtspannung zu reduzieren, was aber auch die Härte reduziert.

Auch REM-Bruchbilder der entsprechenden Schicht zeigen im Gegensatz zu bisher bekannten DLC-Schichten, die die typische Bruchform einer amorphen spröden Schicht mit teils muscheligen Ausbrüchen besitzen, eine feinkörnige gerade Bruchfläche. Schichten mit dem oben beschriebenen Eigenschaftsprofil eignen sich besonders für Anwendungen im Maschinenbau wie zum Beispiel zur Beschichtung von hochbelasteten Pumpen- bzw. Tassenstösseln und Ventiltrieben, Nocken bzw. Nockenwellen wie sie für Kfz-Verbrennungsmotoren und Getriebe verwendet werden, aber auch für den Schutz von hochbelasteten Zahnrädern, Plungern, Pumpenspindeln u.a. Bauteilen bei denen eine besonders harte und glatte Oberfläche mit guten Gleiteigenschaften benötigt wird.

Im Werkzeugbereich können dies Schichten auf Grund ihrer hohen Härte und sehr glatten Oberfläche vorteilhaft vor allem für Umform- (Pressen, Stanzen, Tiefziehen, ...) und Spritzgusswerkzeuge, jedoch auch, mit gewissen Einschränkungen bei der Bearbeitung von Eisenwerkstoffen, für Schneidwerkzeuge eingesetzt werden, insbesondere wenn für die Anwendung ein geringer Reibkoeffizient gepaart mit einer hohen Härte notwendig ist.

Die Wachstumsgeschwindigkeit der DLC-Schicht liegt bei etwa 1-3 $\mu$m/h, die Schichtspannung für das ganze System bei 1-4 GPa und somit im üblichen Bereich von harten DLC-Schichten. Die Leitfähigkeit wird auf Grund der obiger Ausführungen etwa zwischen $\delta = 10^{-6}\Omega$ und $\delta = 5$ M$\Omega$, bevorzugt zwischen $\delta = 10^{-3}\ \Omega$ und $\delta = 500$ k$\Omega$ eingestellt (gemessen wurde hierbei der Oberflächenwiderstand bei einem Abstand der Messelektroden von 20 mm).

Die mit solchermaßen abgeschiedenen DLC-Schichtsystemen erreichten Gleiteigenschaften sind zwar günstiger als die anderer beispielsweise nitridischer und/oder karbidischer Hartstoffschichten, erreichen aber weder die ausserordentlich kleinen Reibkoeffizienten die sich mit Metall/Kohlenstoffschichten verwirklichen lassen, noch sind sie als Einlaufschichten geeignet.

Sollen die Gleit- bzw. Einlaufeigenschaften der DLC-Schicht bzw. des DLC-Schichtsystems weiter verbessert werden, so empfiehlt es sich noch eine abschliessende weichere, einen relativ grossen Anteil an graphitischen Kohlenstoff enthaltende Gleitschicht aufzubringen.

Letztere kann auch vorteilhaft auf andere DLC-Schichten und -Schichtsysteme sowie auf Diamanschichten, insbesonders auf nanokirstalline Diamantschichten, aufgebracht werden.

Im Folgenden wird der Aufbau eines **DLC-Gleitschichtsystems** beschrieben, das vorteilhafterweise, jedoch keinesfalls einschränkend, aus einem wie oben beschriebenen DLC-Schichtsystem mit einer darauf abgelegten Gleitschicht besteht. Überraschenderweise hat sich gezeigt, dass es mit sehr unterschiedlich aufgebauten Gleitschichten möglich ist neben der Verbesserung der Gleit- und eventuell Einlaufeigenschaften, trotz der erhöhten Schichtdicke die ausgezeichnete Haftfestigkeit des DLC-Schichtsystems für das DLC-Gleitschichtsystem zu erhalten.

Eine, insbesonders zur Anwendung auf oben beschriebene erfinderische DLC-Schichtsystem besonders geeignete, vorteilhafte Ausführungsform der reibmindernden Schicht besteht darin eine DLC-Struktur, ohne metallischem Zusatzelement, dafür aber mit zunehmendem Anteil an sp$^2$-Bindungen, bevorzugt in graphitischer Schichtstruktur aufzubringen, womit die Härte der Deckschicht herabgesetzt, sowie die Gleit- und gegebenenfalls Einlaufeigenschaften verbessert werden.

Eine andere vorteilhafte Ausführung der Gleitchicht kann durch Ausbildung einer zweiten, inversen Gradientenschicht erfolgen, bei der der Metallgehalt zur Oberfläche zu, der C-Gehalt aber abnimmt. Dabei wird der Metallgehalt solange erhöht, bis der Reibkoeffizient einen gewünschten niedrigen Wert erreicht. Bevorzugt wird dazu ein oder mehrere Metalle aus der IV, V, VI Nebengruppe, sowie Si verwendet. Besonders bevorzugt Cr, W, Ta, Nb und/oder Si. Der Metallanteil der Schichten sollte dabei zwischen 0.1 und 50 atom%, bevorzugt zwischen 1 und 20 atom% liegen.

Eine weitere bevorzugte Ausführung der reibmindernden Schicht kann durch Aufbringen einer metallischen bzw. karbidischen, insbesonders einer Cr- oder WC-Zwischenschicht, auf die im wesentlichen ausschliesslich aus Kohlenstoff und Wasserstoff bestehende Schicht, hergestellt werden, wobei anschliessend wiederum eine ähnlich der ersten Gradientenschicht ausgebildete Gradientendeckschicht mit abnehmendem Metall- und zunehmenden C-Gehalt folgt. Vorteilhafter- aber nicht zwingender Weise wird dabei dasselbe oder dieselben metallischen Elemente wie in der ersten Gradientenschicht verwendet um die Komplexität der Beschichtungsvorrichtung möglichst gering zu halten. Auch hier sollte der Metallanteil der Schichten dabei zwischen 0.1 und 50 atom%, bevorzugt zwischen 1 und 20 atom% liegen.

Überraschenderweise hat sich gezeigt, dass gerade metallhaltige Gleitschichten auch auf herkömmlich abgeschiedenen DLC-Schichten eine deutliche Verbesserung der Peformance bewirken können. Ein Grund für den damit erzielten geringen Einfluss auf die Gesamthaftung solcher Systeme könnte auf die gut einstellbaren, geringen zusätzlich eingebrachten Schichtspannungen zurückzuFühren sein.

Für alle drei Möglichkeiten hat es sich als vorteilhaft erwiesen, einen abschliessenden Bereich mit unveränderter d.h. konstanter Schichtzusammensetzung vorzusehen, um die auf die jeweilige Anwendung optimierten Eigenschaften der Schicht (z.B. Reibbeiwert, Oberflächenspannung und Benetzbarkeit, ...) auch über einen gewissen Schichtverschleiss aufrecht zu erhalten und ein Einlaufen der Schicht zu ermöglichen.

Der Reibbeiwert kann je nach verwendetem Metall und verbleibendem Überschuss an gaphitischem Kohlenstoff zwischen $\mu = 0.01$ und $\mu = 0.2$ eingestellt werden (bezieht sich auf Stift / Scheibetest unter Normalatmosphäre mit ca. 50% Luftfeuchte).

Die Härte der DLC-Schicht ist bevorzugt auf einen Wert grösser 15 GPa, bevorzugt grösser/gleich 20 GPa eingestellt, die Härte der darüberliegenden weicheren Gleitschicht wird je nach Bedarf eingestellt.

Der integrale Wasserstoffgehalt des entsprechenden Schichtsystems wird bevorzugt auf einen Gehalt zwischen 5-30 Atom% insbesonders zwischen 10-20 Atom% eingestellt.

Die Schichtrauhigkeit kann auf einen Ra-Wert von unter 0.04 bevorzugt unter 0.01, bzw. einen RzDIN-Wert von kleiner 0.8 bevorzugt kleiner 0.5 eingestellt werden.

Die Vorteile solcher DLC-Gleitschichtsystems liegen in der Kombination der grossen Härte der DLC-Schicht, gepaart mit einer gegenüber den bereits guten Laufverhalten der DLC-Schicht nochmals um bis zu einer Grössenordnung verbesserten Gleiteigenschaften. So kann beispielsweise der Reibkoeffizient damit unter $\mu = 0.1$ gesenkt werden. Weiters gelingt es damit erstmals auch DLC-Schichten ein Einlaufverhalten durch anfänglichen Schichtabtrag und graphitische Gegenkörperschmierung zu verleihen, wodurch auch der Verschleiss eines unbeschichteten Gegenörpers deutlich verringert werden kann.

Weiters kann durch Verwendung einer oben beschriebenen reinen DLC-Schicht eine niedrigere Rz- bzw. Ra-Zahl, d.h. eine geringere Rauhigkeit der beschichteten Oberflächen, als mit herkömmlich verwendeten Hartstoffschichten, insbesonders mit dem Arc-Verfahren aufgebrachten, eingestellt werden. Bei solchen bekannten Hartstoff / Gleitschichtkombinationen kann durch insbesonders harte Rauhigkeitsspitzen häufig das Einlaufen des Tribosystems gestört, wenn nicht sogar verhindert und werden, wodurch es zur teilweisen oder gänzlichen Zerstörung der Oberfläche eines Gegenkörpers kommen kann, insbesonders wenn dieser nicht selbst durch eine Hartschicht geschützt ist. Dies ist besonders in Tribosystemen mit hohem Gleitanteil, wie zum Beispiel Kipp- und Gleithebel auf Tassenstössel, unterschiedliche Verzahnungen u.a. von Bedeutung.

Die Überlegenheit von DLC-Gleitschichtsystemen zeigte sich hier in verschiedenen Anwendungen sowohl gegenüber bekannten Hartstoff / Gleitschichtkombinationen als auch gegenüber reinen DLC-Schichtsystemen.

Auch im Werkzeugbereich können dies Schichten auf Grund ihrer hohen Härte und sehr glatten Oberfläche vorteilhaft vor allem für Umform- (Pressen, Stanzen, Tiefziehen, ...) und Spritzgusswerzeuge, jedoch auch mit gewissen Einschränkungen bei der Bearbeitung von Eisenwerkstoffen für Schneidwerkzeuge eingesetzt werden, insbesondere wenn für die Anwendung ein besonders geringer Reibkoeffizient eventuell gepaart mit einem definiertem Einlaufeffekt gewünscht wird. Beispielsweise wurde mit solchermaßen beschichteten Bohrern bereits nach einmaligem Einsatz (ein Bohrloch) ein Poliereffekt auf der Spanablauffläche beobachtet, was beispielsweise für Tieflochbohrungen von Vorteil ist. So kann bei derartigen solchermaßen beschichteten Werkzeugen auf ein teures Nachpolieren der Spanablaufflächen verzichtet werden.

Entsprechende DLC-Gleitschichtsysteme können glatter als herkömmliche beispielsweise mit Lichtbogenverdampfern abgeschieden Hartstoff / Gleitschichtkombinationen (z.B. TiA1N/ /WC/C) abgeschieden und einfacher, in einem durchlaufenden Prozess integriert werden als beispielsweise ebenfalls bekannte Ti-DLC // MoSx-Schichtkombinationen.

## VERFAHREN

Das erfindungsgemässe Verfahren zur Herstellung des DLC-Schichtsystems zeichnet sich durch die Merkmale gemäß Anspruch 1 aus.

Die zu beschichtenden Teile werden in einer für PVD-Verfahren bekannten Weise gereinigt und auf einer Halterungsvorrichtung montiert. Im Gegensatz zu HF-Verfahren können dabei vorteilhafterweise Halterungsvorrichtungen mit- je nach Teilchengeometrie angepasst - 1, 2 oder auch 3 im wesentlichen parallelen Rotationsachsen verwendet werden, wodurch eine grössere Beladungsdichte erzielt werden kann. Die Halterungsvorrichtung mit den zu beschichtenden Teilen wird in die Prozesskammer einer Beschichtungsanlage gebracht und nach Abpumpen auf einen Startdruck von weniger als 10-4 mbar, vorzugsweise 10-5 mbar wird die Prozessfolge gestartet.

Der erste Teil des Prozesses, das Reinigen der Substratoberflächen, wird beispielsweise als Heizprozess durchgeführt, um die noch an der Oberfläche der Teile anhaftenden flüchtigen Substanzen zu entfernen. Dazu wird bevorzugt ein Edelgas - Plasma mittels einer Hochstrom/Niedervoltentladung zwischen einem oder mehreren, in einer an die Prozesskammer angrenzenden Ionisationskammer angeordneten, auf negatives Potential gelegten Filamenten und den auf positives Potential gelegten Halterungsvorrichtungen mit den Teilen gezündet. Dadurch wird ein intensiver Elektronenbeschuss und damit ein Erwärmen der Teile bewirkt. Als besonders günstig hat sich dabei die Verwendung eines Ar/H2-Gemisches erwiesen, da hierbei durch die reduzierende Wirkung des Wasserstoffs gleichzeitig ein Reinigungseffekt der Teileoberflächen erzielt wird. Die Hochstrom/Niedervoltbogenentladung kann dabei mit einem statischen oder vorteilhafterweise im wesentlichen örtlich variabel bewegten magnetischen Feld geführt werden. Statt der oben beschrieben Ionisationskammer kann auch eine Hohlkathode oder eine andere bekannte Ionen- bzw. Elektronenquelle benutzt werden.

Alternativ können natürlich auch andere Heizverfahren wie z.B. Strahlungsheizen oder induktives Heizen verwendet werden.

Nach Erreichen eines, je nach Grundwerkstoff der Teile festzulegenden Termperaturniveaus, kann zusätzlich oder alternativ als Reinigungsprozess ein Aetzprozess gestartet werden, indem beispielsweise zwischen Ionisationskammer und einer Hilfsanode ein Niedervoltbogen gezündet wird, und die Ionen mittels einer negativen Biasspannung von 50-300 V auf die Teile gezogen werden. Die Ionen bombardieren dort die Oberfläche und entfernen restliche Verunreinigungen. Somit wird eine saubere Oberfläche erzielt. Die Prozessatmosphäre kann neben Edelgasen, wie z.B. Argon auch Wasserstoff enthalten.

Der Aetzprozess erfolgt durch Anlegen einer gepulsten Substratbiasspannung ohne oder mit Unterstützung durch einen, wie soeben beschriebenen Niedervoltbogen, wobei ein Mittelfrequenzbias im Bereich von 1 bis 10.000 kHz, insbesondere zwischen 20 und 250 kHz verwendet wird.

Um die Haftung des DLC-Schichtsystems auf dem Substrat zu gewährleisten, wird eine bevorzugt metallische, insbesondere aus Cr oder Ti bestehende Haftschicht mit einem bekannten PVD bzw. Plasma-CVD Verfahren, wie beispielsweise mittels Arcverdampfen, verschiedenen Ionplatingverfahren, bevorzugt jedoch durch kathodisches Sputtern mindestens eines Targets aufgedampft. Zur Unterstützung des Aufdampfens wird am Substrat eine negative Substratbiasspannung angelegt. Der Ionenbeschuss und die damit bewirkte Schichtverdichtung während des Sputterprozesses kann zusätzlich durch einen parallel betriebenen Niedervoltbogen und/oder ein zur Stabilisierung bzw. Intensivierung des Plasmas angelegtes Magnetfeld, und/oder durch das Anlegen einer DC-Biasspannung am Substrat oder durch das Anlegen eines Mittelfrequenzbias zwischen Substrat und Prozesskammer im Bereich von 1 bis 10.000, insbesondere zwischen 20 bis 250 kHz unterstützt werden.

Die Dicke der Haftschicht wird in bekannter Weise durch eine der jeweiligen Anlagengeometrie entsprechenden Wahl der Sputter- bzw. Aufdampfzeit und Leistung eingestellt.

Beispielsweise wird bei vorliegender, wie unten beschriebenen, Anlagengeometrie Cr für die Dauer von 6 Minuten von zwei vorteilhafterweise gegenüberliegenden Targets bei einem Druck zwischen 10-4 bis 10-3 mbar, einem Substratbias von Ubias = -75 V und einer Leistung von ca. 8 kW in einer Ar-Atmosphäre gesputtert.

Nach Aufbringen der Haftschicht wird erfindungsgemäss durch Aufbringen einer Uebergangsschicht ein möglichst fliessender Übergang zwischen Haftschicht und DLC-Schicht sichergestellt.

Das Aufbringen der Uebergangsschicht erfolgt so, dass neben dem plasmagestützten Aufdampfen der Haftschichtkomponenten zeitgleich Kohlenstoff aus der Gasphase abgeschieden wird. Dies erfolgt vorzugsweise über ein Plasma-CVD-Verfahren, bei dem ein kohlenstoffhaltiges Gas, vorzugsweise ein Kohlenwasserstoffgas, insbesondere Acetylen als Reaktionsgas verwendet wird.

Während des Aufbringens der Uebergangsschicht wird am Substrat eine "gepulste", mittelfrequente Substratbiasspannung angelegt und ein Magnetfeld überlagert.

Zur bevorzugten Ausbildung einer Gradientenschicht wird während des Aufbringens der Uebergangsschicht der Anteil der Kohlenstoffabscheidung mit zunehmender Dicke der Uebergangsschicht schrittweise oder kontinuierlich erhöht, bis letztendlich im wesentlichen nur noch eine Kohlenstoffabscheidung stattfindet.

In diesem Prozessstadium wird dann als Deckschicht die diamantähnliche Kohlenstoffschicht durch Plasma-CVD-Abscheidung von Kohlenstoff aus der Gasphase erzeugt, wobei als Reaktionsgas ein kohlenstoffhaltiges Gas, vorzugsweise ein Kohlenstoffwassergas, insbesondere Acetylen verwendet wird. Gleichzeitig wird am Substrat weiterhin eine Substratbiasspannung beibehalten und das überlagerte Magnetfeld aufrechterhalten.

Bei einer bevorzugten Ausführungsform kann das Reaktionsgas zur Abscheidung von Kohlenstoff zur Bildung der Uebergangsschicht und der Deckschicht aus diamantähnlichem Kohlenstoff neben dem kohlenstoffhaltigen Gas zusätzlich Wasserstoff und Edelgas, vorzugsweise Argon oder Xenon, beinhalten. Der eingestellte Druck in der Prozesskammer beträgt dabei zwischen 10-4 bis 10-2 mbar.

Während des Abscheidens der Deckschicht aus diamantähnlichem Kohlenstoff ist es bevorzugt den Anteil des kohlenstoffhaltigen Gases zu erhöhen und den Anteil an Edelgas, insbesondere Argon zu senken.

Die zumindest während der Verfahrensschritte zum Aufdampfen der Haftschicht, Aufbringen der Uebergangsschicht und Abscheiden der Deckschicht am Substrat angelegte Substratbiasspannung ist eine unipolare (negative) oder bipolare Substratbiasspannung, die in einem Mittelfrequenzbereich von 1 bis 10000 kHz, vorzugsweise 20 bis 250 kHz gepulst ist. Die Pulsform kann dabei symmetrisch beispielsweise sinus-, sägezahn-, oder rechteckförmig sein oder asymmetrisch, so dass lange negative und kurze positive Impulszeiten oder grosse negative und kleine positive Amplituden angelegt werden.

Darüber hinaus wird während des Aufbringens der Uebergangsschicht und des Abscheidens der Deckschicht, vorzugsweise während des gesamten Beschichtungsprozesses, das Plasma durch ein Magnetfeld stabilisiert, wobei während des Aufbringens der Uebergangsschicht und der Deckschicht aus diameantähnlichem Kohlenstoff dem Substrat ein longitudinales Magnetfeld mit gleichmässigen Feldlinienverlauf überlagert wird, wobei das Magnetfeld räumlich kontinuierlich oder schrittweise veränderbar ist.

Vorzugsweise wird beim Aufbringen der Uebergangsschicht, zunächst an die Halterungsvorrichtung ein Mittelfrequenzgenerator angeschlossen, der seine Sapnnungsimpulse (Regelung über Steuerung der eingebrachten Leistung ist ebenfalls möglich, aber nicht bevorzugt) in Form eines sinus-, oder eines anderen bi- bzw. auch unipolaren Signalverlaufs abgibt. Der verwendete Frequenzbereich liegt hierbei zwischen 1 bis 10.000 kHz, bevorzugt zwischen 20 und 250 kHz, die Amplitudenspannung zwischen 100 und 3.000 V, bevorzugt zwischen 500 und 2.500 V. In einer anderen vorteilhaften Ausführungsform wird auch für die Durchführung des Aetzprozesses eine Mittelfrequenzspannung an die Substrate angelegt. Bei Verwendung eine bipolaren Substratspannung hat es sich als besonders vorteilhaft erwiesen asymmetrische Impulsformen anzulegen, beispielsweise kann der positive Impuls entweder kürzer oder mit einer kleineren Spannung als der negative Impuls angelegt wird, da die Elektronen rascher dem Feld folgen und auf Grund Ihrer geringen Masse beim Auftreffen vor allem zu einer zusätzlichen Erwärmung der Teile führen, was besonders bei temperaturempfindlichen Grundwerkstoffen zu einer Schädigung durch Überhitzung führen kann. Dieser Gefahr kann auch bei anderen Signalverläufen durch Vorsehen einer sogenannten "OFF-Time" entgegengewirkt werden, bei der zwischen dem Anlegen einzelner oder mehrerer Signalperioden mit Leistungsanteil (= "ON-Time") ein Nullsignal angelegt wird.

Zeitgleich oder mit einer zeitlichen Verzögerung nach Anlegen des Mittelfrequenzsignals, bei Verwendung eines DC-Bias zum Aufbringen der Haftschicht, bzw. nach Aufdampfen der für die Haftschicht gewünschten Schichtdicke bei Verwendung eines Mittelfrequenzbias, wird eine Kohlenwasserstoffgas, bevorzugt Acetylen mit einem schrittweise oder bevorzugt kontinuierlich ansteigenden Gasfluss in den Rezipienten eingelassen. Ebenso zeitgleich oder mit einer gegebenenfalls unterschiedlichen zeitlichen Verzögerung wird vorzugsweise die Leistung des mindestens einen metallischen oder Si-Targets schrittweise oder kontinuierlich heruntergefahren. Bevorzugt wird dabei das Target bis zu einer, je nach erreichtem Kohlenwasserstofffluss von einem Fachmann leicht zu bestimmenden Mindestleistung heruntergefahren, bei der noch ein stabiler Betrieb ohne Vergiftungserscheinungen durch das Reaktivgas möglich ist. Anschliessend wird das mindestens eine Target bevorzugt mit einer oder mehreren beweglich angeordneten Blenden gegen die Prozesskammer abgeschirmt, und abgeschaltet. Diese Massnahme verhindert weitgehend eine Belegung des Targets mit einer DLC-Schicht, womit auf ein sonst notwendiges Freisputtern zwischen einzelnen DLC-Beschichtungschargen verzichtet werden kann. Bei der nächsten durchzuführenden Charge genügt es ein Hochfahren des mindestens einen Targets bei geschlossenen Blenden vorzusehen, um wieder eine völlig blanke, für das Aufbringen der Haftschicht geeignete Targetoberfläche zu erzielen.

Ein wesentlicher Beitrag zur Stabilisierung des erfindungsgemässen DLC-Beschichtungsprozesses wird durch das Ausbilden eines longitudinalen Magnetfeldes erreicht. Das Magnetfeld wird so ausgebildet, dass ein gleichmässiger Feldlinienverlauf in der Prozesskammer gegeben ist. Dazu wird bevorzugt durch zwei im wesentlichen die Prozesskammer an gegenüberliegenden Seiten begrenzende elektromagnetische Spulen Strom so eingeleitet, dass an beiden Spulen ein gleichsinnig gerichtetes, sich gegenseitig verstärkendes Magnetfeld entsteht. Bei kleineren Kammerabmessungen kann eine ausreichende Wirkung gegebenenfalls auch mit nur einer Spule erzielt werden. Damit wird eine annäherend gleichmässige Verteilung des Mittelfrequenzplasmas über grössere Kammervolumen erreicht. Trotzdem kann es durch unterschiedliche Geometrien der zu beschichtenden Teile bzw. der Halterungsvorrichtungen immer noch vereinzelt zur Ausbildung von Nebenplasmen kommen, wenn bestimmte geometrische und elektromagnetische Randbedingungen erfüllt sind. Dem kann durch ein zeitlich und räumlich veränderbares Magnetfeld entgegengewirkt werden, indem die Spulenströme miteinander oder bevorzugt gegeneinander verschoben werden. Beispielsweise wird die erste Spule zunächst während 120 Sekunden durch eine stärkere Stromstärke I durchflossen als die zweite Spule. Während den darauf folgenden 90 Sekunden ist die Stromstärke invers, d.h. das zweite Magnetfeld ist stärker als das erste Magnetfeld. Diese Magnetfeldeinstellungen können periodisch, wie beschrieben, stufenweise oder kontinuierlich vorgenommen werden und damit durch geeignete Wahl der entsprechenden Spulenströme die Ausbildung von stabilen Nebenplasmen vermieden werden.

Erst durch die Verwendung des Magnetfelds und der dadurch erreichten signifikanten Erhöhung der Plasmaintensität ist im Gegensatz zum Stand der Technik möglich auch in niedrigen Druckbereichen von beispielsweise $10^{-3}$ bis $10^{-2}$ mbar einen stabilen CVD-Prozess zur Abscheidung von reinen DLC-Schichten mit hohen Abscheideraten im Bereich von 0,5 bis 5, bevorzugt zwischen 1 - 4 $\mu$m/h zu erzielen. Neben dem Substratstrom ist dabei auch die Plasmaintensität direkt proportional zur Aktivierung des Magnetfeldes. Beide Parameter hängen zusätzlich von der Grösse der angebotenen, mit einem Bias beaufschlagten Flächen ab. Durch die Anwendung niedriger Prozessdrücke können glattere Schichten, mit einer geringeren Anzahl von Wachstumsfehlern sowie geringerer Verunreinigung durch störende Fremdelemente, abgeschieden werden.

Die Wachstumsgeschwindigkeit hängt neben den Prozessparametern auch von der Beladung und der Halterung ab. Insbesonders wirkt sich hierbei aus ob die zu beschichtenden Teile 1-, 2- oder dreifach drehend, auf Magnethalterungen, oder geklemmt bzw. gesteckt befestigt werden. Auch die Gesamtmasse und Plasmadurchgängikeit der Halterungen ist von Bedeutung, so werden beispielsweise mit leichtgebauten Halterungen, z.B. durch Verwendung von Speichentellern, statt Tellern aus Vollmaterial, höhere Wachstumsgeschwindigkeiten und eine insgesamt bessere Schichtqualität erzielt.

Zur weiteren Erhöhung des plasmaverstärkenden Magnetfelds können zusätzlich zu dem longitudinalen, die gesamte Prozesskammer durchdringenden Magnetfeld (Fernfeld) weitere lokale Magnetfelder - sogenannte Nahfelder - vorgesehen werden. Besonders vorteilhaft ist dabei eine Anordnung bei der zusätzlich zu mindesten einem Magnetronmagnetsystem des mindestens einen Targets weitere bevorzugt permanente Magnetsysteme an den die Plasmakammer begrenzenden Wänden angebracht werden, die eine ähnliche oder die gleiche magnetische Wirkung wie das mindesten eine Magnetronmagnetsystem haben. Dabei kann entweder bei allen Magnetron- und weiteren Magnetsystemen derselbe Aufbau oder aber bevorzugt eine Umkehrung der Polungen vorgenommen werden. Dadurch ist es möglich die einzelnen Nahfelder der Magnet- bzw. Magnetronmagnetsysteme gleichsam als einen die Prozesskammer umgebenden magnetischen Einschluss auszubilden um somit eine Absorption der freien Elektronen an den Wänden der Prozesskammer zu verhindern.

Erst durch eine Kombination der wesentlichen Merkmale des erfinderischen Verfahrens ist es möglich, eine wie oben beschriebene Schicht herzustellen. Erst der Einsatz von durch Magnetfelder stabilisierten Plasmen sowie der abgestimmte Einsatz der Substratbiasspannung ermöglicht die Verwendung der für übliche PVD-Prozesse optimierten Halterungen mit hoher Packungsdichte und Prozesssicherheit. Das Verfahren zeigt, wie der Ablauf bzw. die Kombination von Gleichstrom- und Mittelfrequenzplasmen in optimaler Weise für die Abscheidung einer DLC-Schicht eingesetzt werden kann.

Zum Aufbau der unterschiedlichen Gleitschichten werden verschiedene Verfahren angewandt.

Zum Abscheiden einer **graphitisierten DLC-Schicht** wird nach Aufbringen der reinen DLC-Schicht, bei sonst im wesentlichen gleich oder ähnlich eingestellten Prozessparametern, die Biasspannung entweder stufenweise oder kontinuierlich auf einen Wert über 2000 V, vorzugsweise zwischen 2000 und 2500 V eingestellt. Mit steigender Spannung wächst dabei der Anteil der in graphitischer $sp^2$-Bindung aufwachsenden C-Atome. Damit können, in besonders einfacher Weise, der davor abgeschiedenen reinen DLC-Schicht verbesserte Gleiteigenschaften verliehen werden.

Zum Aufbringen einer **inverse Gradientenschicht** gibt es unterschiedliche Möglichkeiten. Im einfachsten Fall kann der Prozess zunächst unter Beibehaltung derselben Paramter wie bei der vorhergehenden DLC-Schicht unter Zuschalten eines oder mehrere metallischen, bzw. metallkarbidischen. Als vorteilhaft hat es sich jedoch erwiesen, zunächst entweder den Kohlenwasserstoffanteil im Gasfluss zu erniedrigen, den Edelgasanteil zu erhöhen oder beide Massnahmen gemeinsam durchzuführen, um ein Vergiften der Targets und damit instabile Prozesszustände zu vermeiden. Weiters kann ein Anfahren der Targets hinter zunächst geschlossenen Blenden von Vorteil sein um eventuelle Dropplets auf den Substraten zu vermeiden. Anschliessend wird die Leistung des mindestens einen Targets stufenweise oder bevorzugt kontinuierlich bis auf einen Wert erhöht, bei dem die Schicht bestimmte erwünschte Schichteigenschaften (Reibbeiwert, ...) aufweist. Die übrigen Parameter werden bevorzugt unverändert belassen, jedoch ist eine zusätzliche Anpassung falls gewünscht jederzeit möglich. Anschliessend wird der Prozess noch bevorzugt unter Konstanthaltung der Einstellung zu Ende geführt, bis eine gewünschte Schichtdicke der inversen Gradientenschicht erreicht ist.

Eine weitere vorteilhafte Möglichkeit zur Ausbildung einer inversen Gradientenschicht ergibt sich wenn zusätzlich zu oder statt des erwähnten Kohlenwasserstoffgases noch siliziumhaltige bzw. silizium- und sauerstoff- bzw. stickstoffhaltige Gase, wie beispielsweise Mono- und Disilane, Siloxane, Hexamethyldisiloxan, Hexamethyldisilazan, Dimethyldiethoxysilan, Tetramethysilan etc. eingelassen werden um die Eigenschaften der Schicht, insbesonders deren Härte und Reibkoeffizienten zu beeinflussen. Damit ist es auch möglich ohne zusätzliches Einschalten eines oder mehrerer Sputtertargets eine Gradientenschicht mit beispielsweise zur Oberfläche hin ansteigendem Silizium-, Sauerstoff- und /oder Stickstoffgehalt herzustellen. Das Aufbringen einer Gleitschicht als Gradientendeckschicht, kann entweder direkt auf einer DLC-Schicht oder nach Aufbringen einer metallischen bzw. karbidischen Zwischenschicht erfolgen.

Beispielsweise wird für die Erzeugung der reibmindernden Deckschicht die dazu verwendete mindestens eine Quelle, ähnlich wie bereits oben beschrieben, allerdings nach stärkerem gegebenefalls auf 0% Absenken des Kohlenstoffgehalts des Prozessgases eingeschaltet. Zur Herstellung der reibmindernden Deckschicht können karbidische oder metallische Targets verwendet werden, wobei die karbidischen Targets den Vorteil bieten einen insgesamt höheren C-Gehalt, bei sehr hoher Belastbarkeit der Schichten zu ermöglichen. Der Gehalt an graphitischem Kohlenstoff wird wiederum durch Einlassen eines C-haltigen Reaktivgases eingestellt, wobei vorteilhafterweise der Gasfluss ab Einschalten der zur Herstellung der MeC/C-Schicht verwendeten Targets, oder mit einer zeitlichen Verzögerung, mittels einer Rampenfunktion erhöht und am Schluss der Beschichtung für eine bestimmte Zeit konstant gehalten wird.

Eine besonders vorteilhafte Ausführung der Schicht ergibt sich, wenn auf der DLC-Schicht zunächst eine dünne (0.01 -0.9 μm) karbidische, wie zum Beispiel WC-Schicht abgeschieden wird. Überraschenderweise hat sich gezeigt, dass gerade karbidische Schichten besonders gut als Haftvermittler auf einer bereits abgelegte DLC-Schicht geeignet sind. Nach aussen hin wird der Schichtaufbau von einer WC/C-Schicht mit einem zunehmenden C-Gehalt und einer Dicke von ca. 0.1-5 μm abgeschlossen. Vorteilhafterweise wird die Schichtdicke der MeC/C-Schicht geringer als die der reinen DLC-Schicht gewählt.

Eine weitere bevorzugte Ausführung eines DLC-Gleitschichtsystems ergibt sich wenn die abschliessende Gleitschicht auf einer Diamantschicht aufgebracht wird, die beispielsweise mittels einer Hochstromniedervoltbogenentladung oder der Hot-Filament-Technik abgeschieden wurde.

## ANLAGE

Eine Vorrichtung zur Durchführung des Beschichtungsverfahrens umfasst eine Vakuumkammer mit einem Pumpsystem zur Erzeugung eines Vakuums in der Vakuumkammer, Substrathalterungen zur Aufnahme der zu beschichtenden Substrate, mindestens einer Gasversorgungseinheit zum Zudosieren von Prozessgas, mindestens eine Verdamper-Vorrichtung zur Bereitstellung von Beschichtungsmaterial zum Aufdampfen, eine Lichtbogenerzeugungseinrichtung zum Zünden eines Gleichspannungsniedervoltbogens, eine Vorrichtung zur Erzeugung einer Substratbiasspannun und mindestens eine oder mehrere Magnetfelderzeugungseinrichtungen zur Ausbildung eines magnetischen Fernfelds.

Vorzugsweise werden die Magnetfelderzeugungseinrichtungen durch mindestens eine Helmholtzspule, vorzugsweise ein Paar von Helmholtzspulen gebildet.

Bei der Verwendung von Helmholtzspulen ist das erzeugbare Magnetfeld bzw. die Magnetflussdichte durch die Stromstärke in den Spulen sowohl örtlich als auch zeitlich steuerbar.

Eine weitere Möglichkeit zur Erzeugung eines longitudinalen Magnetfeldes ergibt sich, wenn zwei Magnetrons an gegenüberliegenden Seiten des Rezipienten angeordnet werden, und diesen zusätzlich zumindest jeweils eine elektromagnetische Spule zugeordnet ist. Die jeweils zugeordnete Spule wird vorteilhafterweise so angebracht, dass sie im wesentlichen den gesamten seitlichen Umfang der Magnetronanordnung begrenzt. Die Polungen der gegenübeliegenden Magnetronmagnetsysteme werden dabei gegengleich ausgerichtet, d.h. dem Nordpol des einen Systems steht ein Südpol des anderen Systems gegenüber und umgekehrt. Gleichzeitig werden die jeweils zugeordneten Spulen so an eine Stromquelle angeschlossen, dass sich die Felder der Magnetspulen entsprechend einer Helmholtzanordnung zu einem geschlossenen Magnetfeld ergänzen und die Polung der Aussenpole der Magnetronmagnetsysteme und der Magnetspulen gleichsinnig ist. Derartige Vorrichtungen lassen sich vorteilhaft sowohl zur Verstärkung des Magnetronplasmas als auch zur Ehöhung der Ionisation während des Plasma-CVD-Prozeses einsetzen.

Weiterhin umfasst die Vorrichtung eine Vorrichtung zur Erzeugung einer Substratbiasspannung, die kontinuierlich oder schrittweise die angelegte Substratbiasspannun verändern kann und entsprechend auch bipolar oder unipolar betreibbar ist. Die Vorrichtung ist geeignet, eine im Mittelfrequenzbereich gepulste Substratbiasspannung zu erzeugen.

Die bei der Vorrichtung verwendeten Verdampfvorrichtungen umfassen Sputtertargets, insbesondere Magnetronsputtertargets, Arcquellen, thermische Verdampfer und dergleichen. Vorteilhaft dabei ist, dass die Verdampfervorrichtung von der übrigen Prozesskammer beispielsweise durch schwenkbare Blenden abtrennbar ist.

Die Vorrichtung weist vorteilhafterweise eine Substratheizung in Form einer induktiven Heizung, Strahlungsheizung oder dergleichen auf, um die Substrate in einem Heizschritt vor der Beschichtung reinigen zu können. Bevorzugt wird aber das Zünden eines Plasmas verwendet.

Unter anderem dazu ist in der Vorrichtung eine Niedervoltbogenerzeugungseinrichtung vorgesehen, die eine Ionenquelle mit einem Filament, vorzugsweise einem Refraktärfilament, insbesondere aus Wolfram, Tantal oder dergleichen in einer Ionisatioskammer sowie eine Anode und eine Gleichspannungsversorgung umfasst. Die Ionenquelle ist hierbei mit dem negativen Pol der Gleichspannungsversorung verbunden. Der positive Pol der Gleichsapnnungsversorgung ist mit der Anode verbunden, so dass ein Niedervoltlichtbogen zwischen Ionenquelle und Anode gezündet werden kann. Auch die Ionenquelle ist ähnlich wie die Verdampfer-Vorrichtung von der eigentlichen Prozesskammer abtrennbar, z.B. durch eine Lochblende, z.B. aus Wolfram, Tantal oder einem ähnlichen Refraktärmetall.

Um einen gleichmässigen Beschichtungsprozess für alle Seiten der Substrate zu ermöglichen, ist es weiterhin vorgesehen, dass die Substrathalterungen beweglich sind und sich vorzugsweise um mindestens eine oder mehrere Achsen drehen können.

Durch die vorteilhafte Kombination der mittelfrequenten Substratspannungsversorung und einer Helmholtz-Spulenanordnung, die auch durch seitlich angebrachte, zwei gegenüberliegende Targets umfassende Spulen verwirklicht werden kann, ist es erstmals im industriellen Massstab möglich auch bei tiefen Drücken ein stabiles Mittelfrequenzplasma zur Durchführung eines DLC-Prozesses zu nutzen. Die damit hergestellten Schichten weisen im Gegensatz zu mit anderen Systemen hergestellten DLC-Schichten stark verbesserte Eigenschaften auf.

Mit vorliegender Beschichtungsanlage und dem oben beschriebenen Verfahren lassen sich erstmals dicke reine DLC-Schichten mit ausgezeichneter Haftung herstellen. Zusätzlich kann bei Änderung der Verfahrensparameter auch ein Grossteil der bisher bekannten Plasmaverfahren zur Herstellung von Metallkohlenstoff- oder Mischschichten mit anderen Elementen wie z.B. Silizium oder F und zur Herstellung von Mehrlagenschichten oder von einfachen, bekannten, mittels PVD- und/oder CVD-Verfahren abgeschiedene Schichtsystemen durchgeführt werden.

Weiters lassen sich zusätzlich DLC-Gleitschichtsysteme mit einstellbarem Gleit- und Einlaufverhalten abscheiden.

Weitere Vorteile, Kennzeichen und Merkmale der Erfindung werden anhand der nachfolgenden detaillierten Beschreibung von bevorzugten Ausführungsformen anhand der beigefügten Zeichnungen deutlich. Dabei zeigen die Figuren sämtlich in rein schematischer Weise in

Figur 1    eine Vorrichtung im Querschnitt
Figur 2    die Vorrichtung der Figur 1 in Draufsicht
Figur 3    Einfluss des Spulenstroms auf den Substratstrom
Figur 4    Prozessparameter Gradientenschicht
Figur 5    Prozessparameter DLC-Schicht
Figur 6    REM-Bruchaufnahme einer DLC-Schicht
Figur 7    Prozessparameter Gesamtverlauf
Figur 8    Prozessparameter graphitisierte DLC-Schicht
Figur 9    Prozessparameter inverse Gradientenschicht
Figur 10    Prozessparameter Gradientenschicht
Figur 11    Prozessparameter $H_2$-reiche Schicht

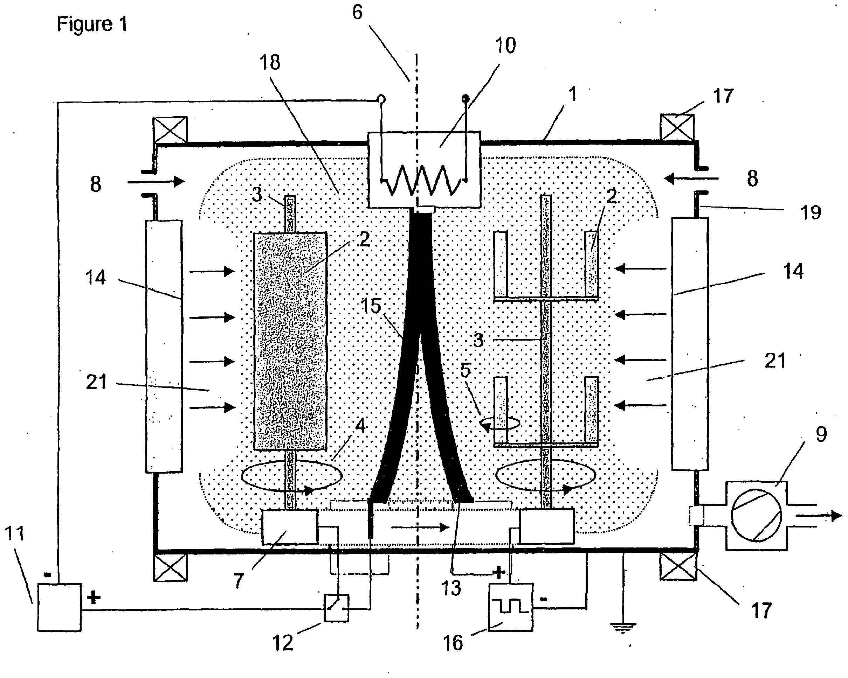

FIG. 1 zeigt einen schematischen Querschnitt durch die Prozesskammer 1 einer Beschichtungsanlage. Die zu beschichtenden Teile 2 sind auf einer bzw. mehreren Halterungsvorrichtungen 3 montiert, die Mittel zur Erzeugung einer zumindest einfachen 4, bei Bedarf auch zweifachen 5 Rotation der Teile umfasst. In einer besonders vorteilhaften Ausführung werden die Halterungsvorrichtungen 3 auf einem zusätzlich um die Anlagenachse 6 drehbaren Karussell 7 positioniert.

Über Gaseinlässe 8 können die unterschiedlichen Prozessgase, insbesondere Ar und Azetylen, in die Prozesskammer mittels geeigneter, hier nicht dargestellten Regelvorrichtungen zugeführt werden.

Ein hochvakuumtauglicher Pumpstand 9 ist an die Kammer angeflanscht.

Eine Ionenquelle 10 ist vorzugsweise im Bereich der Anlagenachse angeordnet, die an den negativen Ausgang einer Gleichspannungsversorgung 11 angeschlossen ist. Der positive Pol der Gleichspannungsversorgung 11 kann je nach Prozessschritt über einen Schalter 12 an das Karussell 7 bzw. an die Halterungsvorrichtung 3 und die damit elektrisch verbundenen Teile 2 (Heizprozess) oder an die Hilfsanode 13 (Aetzprozess, bzw. bei Bedarf auch während der Beschichtungsprozesse) angelegt werden.

An den Wänden der Prozesskammer 1 ist mindestens eine Verdampferquelle 14, bevorzugt ein Magnetron oder ein Lichtbogenverdampfer zum Aufbringen der Haft- und Gradientenschicht vorgesehen. In einer anderen hier nicht dargestellten Ausführungsform der Verdampferquelle 14 kann diese als anodisch geschalteter Tiegel zentral im Boden der Prozesskammer 1 angebracht sein. Dabei wird das Verdampfungsgut zur Herstellung der Uebergangs- oder Gradientenschicht mittels Erhitzen durch den Niedervoltbogen 15 in die Gasphase übergeführt.

Ferner ist eine zusätzliche elektrische Spannungsversorgung 16 vorgesehen, mit deren Hilfe an die Substrate eine periodisch veränderliche Mittelfrequenzspannung im Bereich zwischen 1-10.000, bevorzugt zwischen 20 und 250 kHz angelegt werden kann.

Die elektromagnetischen Spulen 17 zur Erzeugung eines longitudinalen, den Plasmaraum durchdringenden Magnetfelds sind an gegenüberliegenden Begrenzungswänden der Prozesskammer 1 angeordnet und werden durch mindestens eine, vorzugsweise zwei getrennte, hier nicht näher dargestellte DC-Spannungsquellen gleichsinnig gespeist.

Alle Beschichtungsversuche wurden auf einer ähnlich FIG. 1 ausgeführten Prozesskammer folgender Abmessungen durchgeführt:

Kammerhöhe 920 mm, Durchmesser 846 mm, Volumen 560 1.

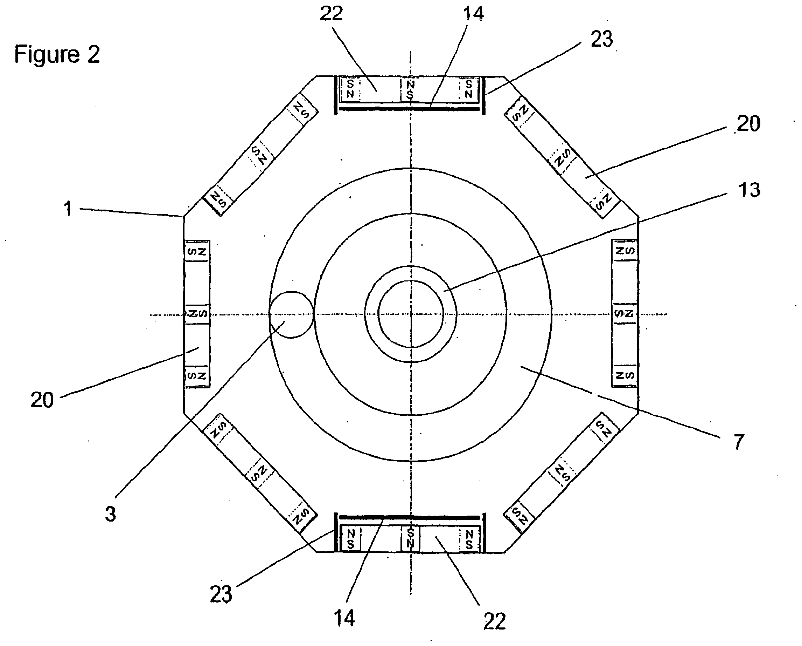

Als zusätzliche Massnahmen zur Verstärkung bzw. gleichmässigeren Ausformung des Magnetfelds und damit des MF-Plasmas 18 können an den Seitenwänden 19 der Plasmakammer 1 Magnetsysteme 20 zur Ausbildung mehrerer magnetischer Nahfelder 21 angebracht werden. Dabei werden vorteilhafterweise gegebenenfalls unter Einbeziehung des mindestens einen Magnetronmagnesystems 22, wie beispielsweise in FIG. 2 dargestellt, abwechselnd Magnetsysteme mit NSN bzw. SNS Polung angeordnet und damit ein magnetischer tunnelförmiger, schleifenförmiger Einschluss des Plasmas in der Prozesskammer bewirkt.

Bevorzugterweise werden die Magnetsysteme 20 für die Nahfelderzeugung als Magnetronmagnetsysteme ausgebildet.

Die einzelnen Systeme der Beschichtungsanlage werden vorteilhafterweise durch eine Prozesssteuerung miteinander in Beziehung gesetzt. Damit ist es möglich, neben den Grundfunktionen einer Vakummbeschichtungsanlage (Pumpstandsteuerung, Sicherheitsregelkreise, etc.), die verschiedenen plasmaerzeugenden Systeme wie Magnetrons mit der hier nicht näher beschriebenen Magnetronversorgung, Ionisationskammer 1 und Hilfsanode 13 bzw. Karussell 7 und Gleichspannungsversorgung 11, sowie Karussell 7 und Mittelfrequenzgenerator 16, sowie die entsprechende Einstellung der Gasflüsse, sowie die Steuerung der gegebenenfalls unterschiedlichen Spulenströme in flexibler Weise aneinander anzupassen und für unterschiedliche Prozesse zu optimieren.

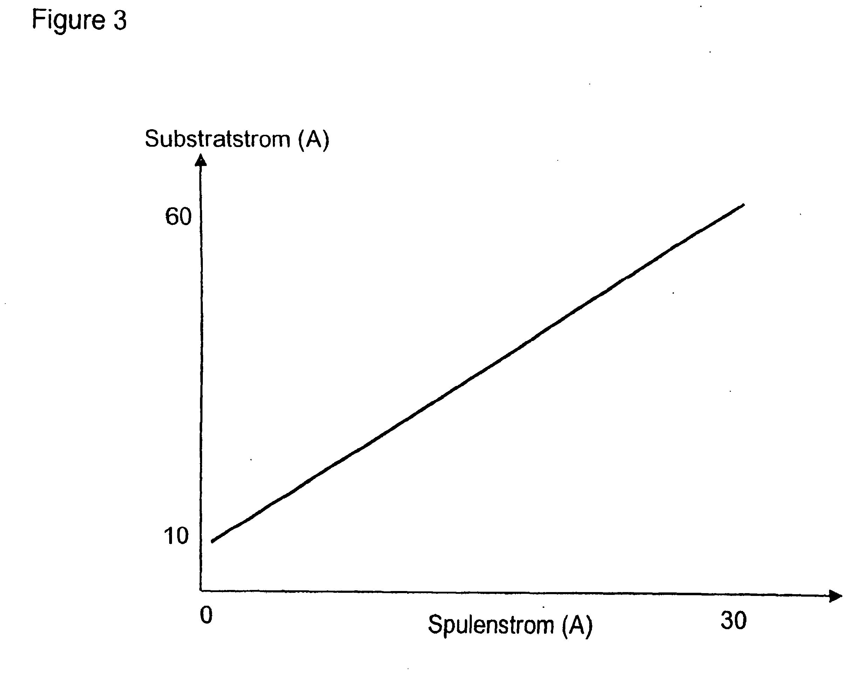

Figur 3 zeigt den Zusammenhang zwischen Substratstrom und Spulenstrom bei Verwendung von Helmholtzspulen zum Aufbau eines Magnetfeldes. Es zeigt sich, dass der Substratstrom, und damit die Plasmaintensität direkt proportional zum Spulenstrom und damit zum Magnetfeldaufbau sind. Dies zeigt deutlich die positive Wirkung eines überlagerten Magnetfeldes.

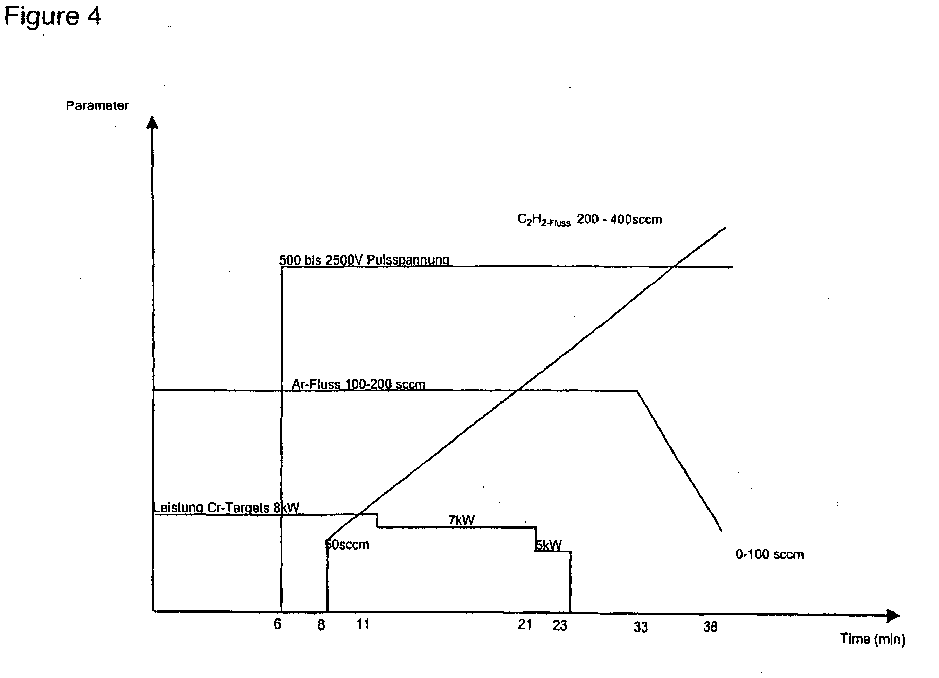

In Figur 4 wird beispielhaft der Verlauf einzelner Parameter während des Aufbringens einer Gradientenschicht dargestellt: Bei sonst gegenüber der Haftschicht gleich bleibenden Parametern wird der Substratbias von Gleichstrom auf Mittelfrequenz mit einer bevorzugten Amplitudenspannung zwischen 500 und 2500 V und einer Frequenz zwischen 20 und 250 kHz, umgeschaltet. Nach ca. 2 Minuten wird eine Acetylenrampe bei 50 sccm gestartet und über ca. 30 Minuten auf 350 sccm gefahren. Ca. 5 Minuten nach Einschalten des Mittelfrequenzgenerators wird die Leistung der verwendeten Cr-Targets auf 7 kW, nach weiteren 10 Minuten auf 5 kW zurückgenommen, und dort noch 2 Minuten konstant gehalten. Anschliessend werden Blenden vor die Targets gefahren und diese abgeschaltet, womit die Abscheidung der im wesentlichen aus Kohlenstoff-, in geringen Mengen Wasserstoff und noch geringeren Mengen Argonatomen aufgebauten "reinen" DLC-Schicht beginnt.

Dazu kann im einfachsten Fall der Prozess mit ausgeschalteten Bedampfungsquellen, im übrigen aber gleichen Parametern wie bei der vorhergehenden Gradientenschicht zu Ende geführt werden. Als vorteilhaft hat es sich jedoch erwiesen, im Laufe der Abscheidung der reinen DLC-Schicht entweder den Kohenwasserstoffanteil im Gasfluss zu erhöhen, den Edelgasanteil abzusenken oder besonders bevorzugt beide Massnahmen gemeinsam durchzuführen. Auch hier kommt wieder einer, wie oben beschriebenen Ausbildung eines longitudinalen Magnetfeldes eine besondere Bedeutung zur Erhaltung eines stabilen Plasmas zu.

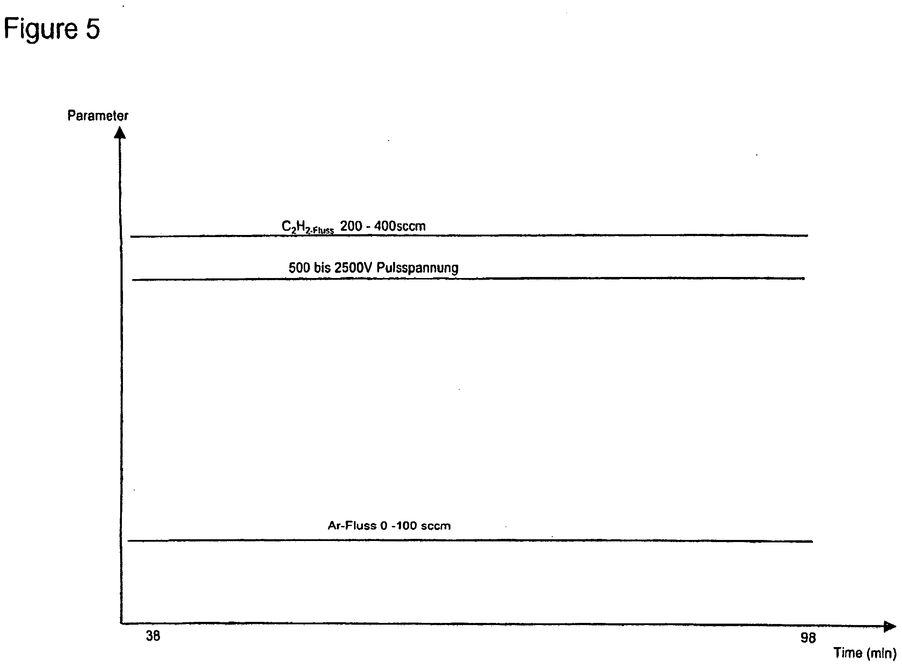

In den Figuren 4 und 5 wird beispielhaft der Verlauf einzelner Parameter während des Aufbringens der reinen DLC-Schicht dargestellt: Nach Abschalten der verwendeten Cr-Targets wird bei gleichbleibend eingestellter Mittelfrequenzversorgung und gleichbleibendem Argonfluss die während der Gradientenschicht begonnene Acetylenrampe ca. 10 Minuten gleichförmig bis zu einem Fluss zwischen ca. 200 - 400 sccm gesteigert. Anschliessend wird der Argonfluss über einen Zeitraum von 5 Minuten kontinuierlich auf einen Fluss zwischen ca. 0 - 100 sccm zurückgenommen. Die nächsten 55 Minuten wird der Prozess bei gleichbleibenden Einstellungen zu Ende gefahren.

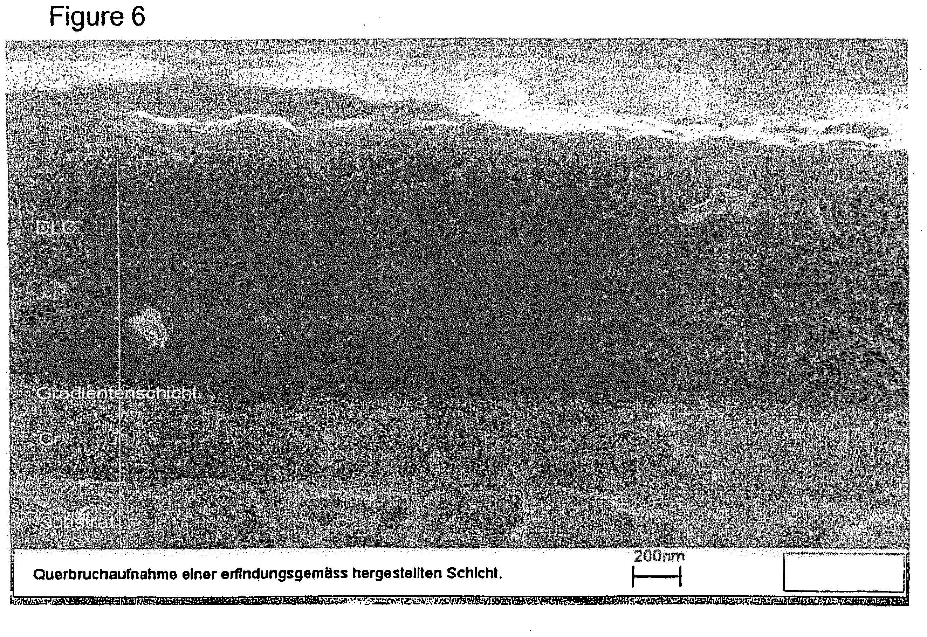

Figur 6 zeigt eine rasterelektronenmikroskopische Aufnahme einer Bruchfläche eines solchermaßen hergestellten DLC-Schichtsystems. Deutlich ist zu erkennen, dass im Bereich der Deckschicht aus diamantähnlichem Kohlenstoff eine feinkörnige Struktur vorliegt, so dass die DLC-Schicht einen polykristallinen Charakter aufweist.

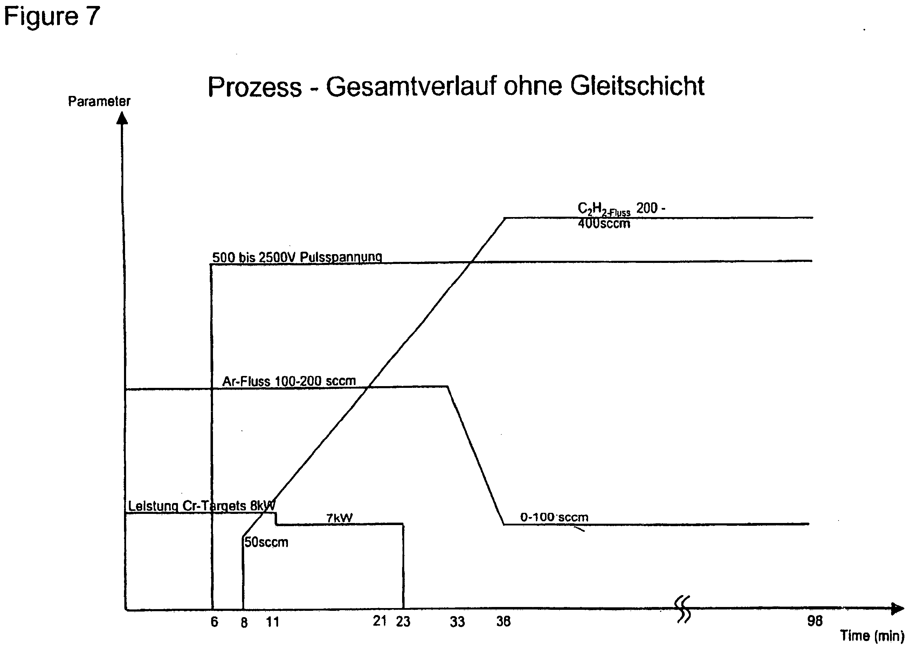

Figur 7 zeigt beispielhaft den Gesamtverlauf einzelner Prozessparameter während des Aufbringens eines solchermaßen hergestellten DLC-Schichtsystems.

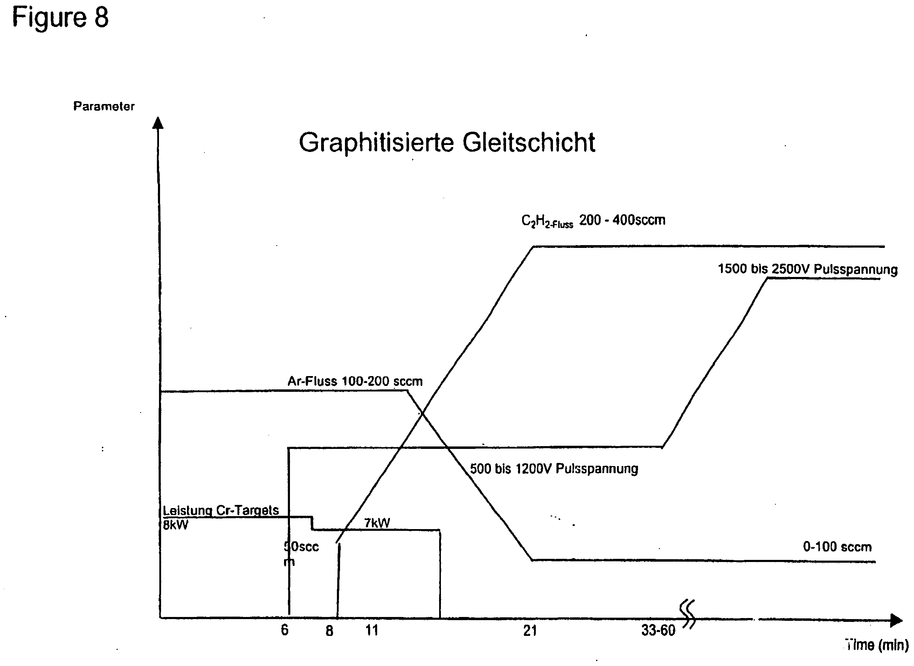

Figur 8 zeigt beispielhaft den Gesamtverlauf einzelner Prozessparameter während des Aufbringens eines solchermaßen hergestellten DLC-Gleitschichtsystems mit graphitisierter Gleitschicht. Dazu wird nach Aufbringen der DLC-Schicht, je nach gewünschter Schichtdicke beispielsweise nach 33 bis 60 Minuten Beschichtungsdauer, bei sonst gleichbleibenden Prozessparametern, der gepulste Substratbias mittels einer Spannungsrampe auf einen Wert zwischen 1500 und 2500 V eingestellt und anschliessend unter konstanten Bedingungen eine Einlaufschicht abgeschieden.

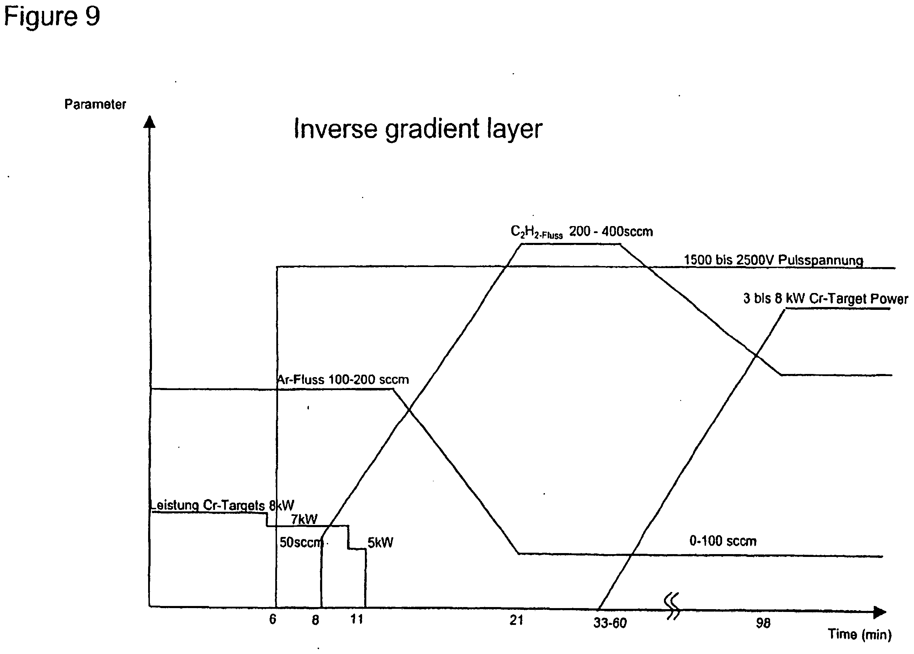

Figur 9 zeigt beispielhaft den Gesamtverlauf einzelner Prozessparameter während des Aufbringens eines solchermaßen hergestellten DLC-Gleitschichtsystems mit einer inversen Gradientenschicht. Dazu wird nach Aufbringen der DLC-Schicht, je nach gewünschter Schichtdicke beispielsweise nach 33 bis 60 Minuten Beschichtungsdauer, die Leistung das mindestens einen Targets hinter geschlossenen Blenden 10 Minuten, mit 5 kW, hinter den Blenden freigesputtert, anschliessend die Blenden geöffnet und innerhalb von ca. 20 Minuten auf 7 kW hochgefahren. Gleichzeitig wird die Acetylenrampe beispielsweise bei 350 sccm gestartet und über ca. 30 Minuten auf 50 sccm gefahren. Anschliessend wird der Prozess noch bevorzugt unter Konstanthaltung der Einstellungen zu Ende geführt, bis eine gewünschte Schichtdicke der Einlaufschicht erreicht ist.

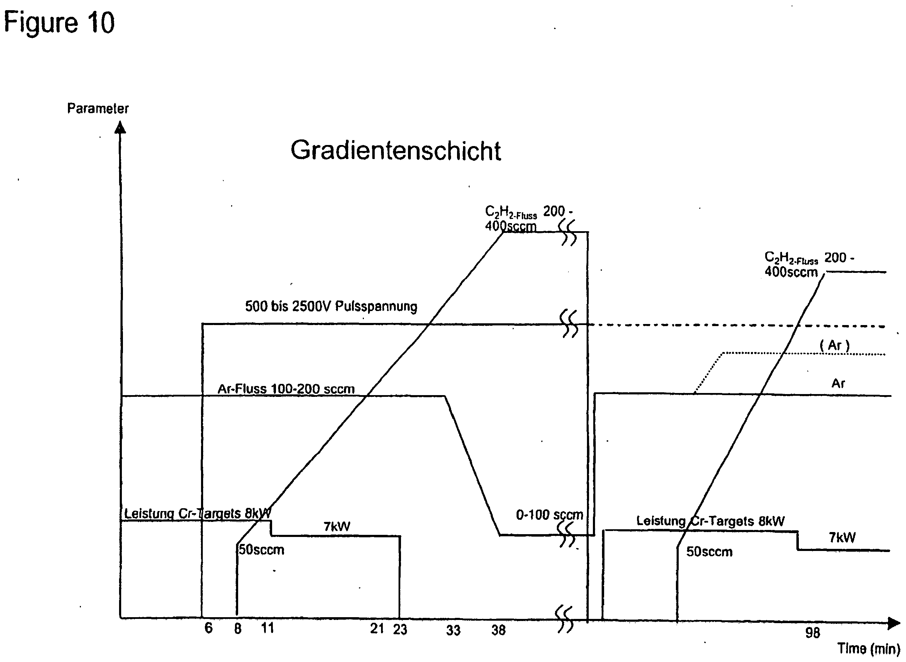

Figur 10 zeigt beispielhaft den Verlauf einzelner Prozessparameter während des Aufbringens einer Gradientenschicht als Gleitschicht. Diese kann ähnlich wie die Übergangsschicht, allerdings auch ohne metallische Haftschicht, ausgeführt werden. Vorteilhafterweise wird auch hier eine Einlaufschicht mit konstanten Parametern als Schichtabschluss vorgesehen.

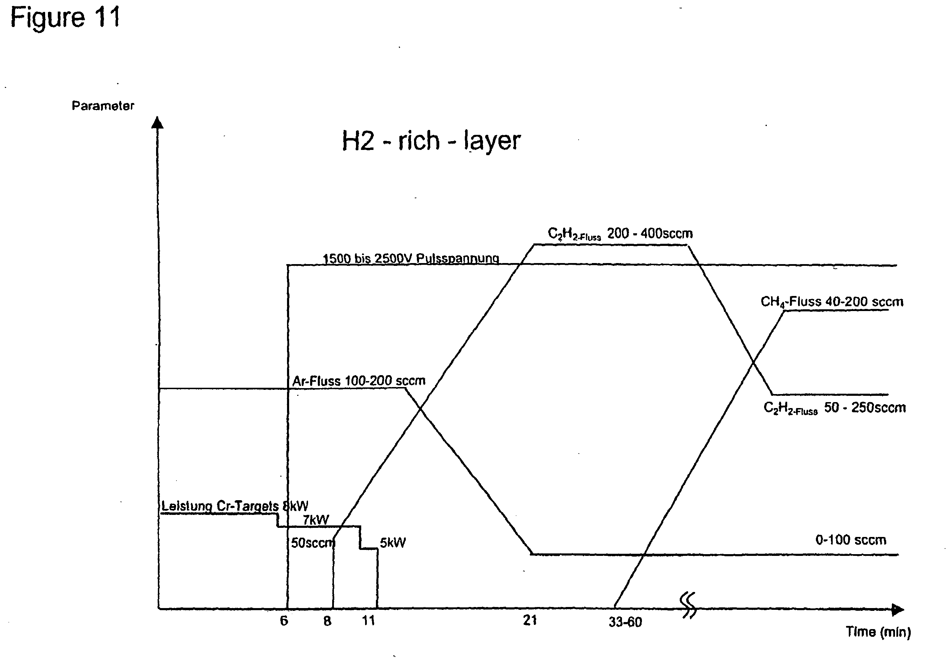

Figur 11 zeigt beispielhaft den Gesamtverlauf einzelner Prozessparameter während des Aufbringens eines solchermaßen hergestellten DLC-Gleitschichtsystems mit einer $H_2$-reichen Gleitschicht. Dazu wird nach Aufbringen der DLC-Schicht, eine Methanrampe gestartet und beispielsweise über ca. 30 Minuten von 0 auf 100 sccm gefahren. Gleichzeitig wird eine Acetylenrampe beispielsweise bei 350 sccm gestartet und über ca. 30 Minuten auf 120 sccm heruntergefahren. Die Einlaufschicht wird als Schichtabschluss mit konstanten Parametern gefahren.

**Beispiele (nicht erfindungsgemäß)**

**Prozessbeispiele 1**

**Heizprozess**

Die Prozesskammer wird bis auf einen Druck von etwa 10-5 mbar abgepumpt und die Prozessfolge gestartet. Als erster Teil des Prozesses wird ein Heizprozess durchgeführt, um die zu beschichtenden Substrate auf eine höhere Temperatur zu bringen und von flüchtigen Substanzen an der Oberfläche zu befreien. Bei diesem Prozess wird ein Ar-Wasserstoff-Plasma mittels des Niedervoltbogens zwischen der Ionisationskammer und einer Hilfsanode gezündet. Die folgende Tabelle 1 zeigt die Prozessparameter des Heizprozesses:

| Ar-Fluss | 75 sccm |
|---|---|
| Substrat-Bias Spannung [V] | 0 |
| Strom des Niedervoltbogens | 100 A |
| Wasserstoff-Fluss | 170 sccm |
| Strom obere Spule | Schwellend zwischen 20 und 10 A |
| Strom untere Spule | Gegengleich schwellend zwischen 20 und 5 A |
| Periodendauer zwischen max. und min. Spulenstrom | 1.5 min |
| Heizzeit | 20 min |

Die Helmholtzspulen werden zur Aktivierung des Plasmas eingesetzt und werden zyklisch angesteuert. Der Strom der oberen Spule wird dabei mit einer Periodendauer von 1.5 min zwischen 20 und 10 A variiert, der Strom der unteren Spule wechselt im selben Takt gegengleich zwischen 5 und 20 A.
Dabei erwärmen sich die Substrate und die störenden an der Oberflächen anhaftenden flüchtigen Substanzen werden in die Gasatomsphäre getrieben, wo sie von den Vakuumpumpen abgesaugt werden.

**Aetzprozess**

Wenn eine gleichmässige Temperatur erreicht ist, wird ein Aetzprozess gestartet, indem die Ionen aus dem Niedervoltbogen mittels einer negativen Biasspannung von 150V auf die Substrate gezogen werden. Die Ausrichtung des Niedervoltbogens und Intensität des Plasmas werden dabei von dem in horizontaler Ausrichtung angebrachten Helmholtzspulenpaar unterstützt. Folgende Tabelle zeigt die Parameter des Aetzprozesses.

| Ar-Fluss | 75 sccm |
|---|---|
| Substratspannung | -150 V |
| Niedervolt-Bogenstrom | 150 A |

**Cr-Haftschicht**

Mit der Aufbringung der Cr-Haftschicht wird begonnen, indem die Cr-Magnetron-Sputtertargets aktiviert werden. Der Ar-Gasfluss wird auf 115 sccm eingestellt. Die Cr-Sputter-Targets werden mit einer Leistung von 8 kW angesteuert und die Substrate werden nun für eine Zeit von 6 min an den Targets vorbei rotiert. Der sich einstellende Druckbereich liegt dann zwischen 10-3 mbar und 10-4 mbar. Der Sputterprozess wird durch die Zuschaltung des Niedervoltbogens und das Anlegen einer negativen DC-Biasspannung von 75 V am Substrat unterstützt.
Nach der Hälfte der Cr-Sputterzeit wird der Niedervoltbogen abgeschaltet und die Abscheidung wird für den Rest der Cr-Sputterzeit nur mit Hilfe des vor den Cr-Targets aktiven Plasmas getätigt.

**Gradientenschicht**

Nach Ablauf dieser Zeit wird durch Einschalten eines Sinusgenerators ein Plasma gezündet. Acetylengas mit einem Anfangsdruck von 50 sccm eingelassen und der Fluss jede Minute um 10 sccm erhöht.

Der Sinus-Plasmagenerator wird dabei bei einer Frequenz von 40 kHz auf eine Amplitudenspannun von 2400 V eingestellt. Der Generator zündet zwischen den Substrathalterungen und der Gehäusewand eine Plasmaentladung. Die am Rezipienten angebrachten Helmholtzspulen sind dabei beide mit einem konstanten Stromdurchfluss von 3 A in der unteren Spule und 10 A in der oberen Spule aktiviert. Bei einem Acetylenfluss von 230 sccm werden die Cr-Targets deaktiviert.

**DLC-Beschichtung**

Wenn der Fluss des Acetylens den Wert von 350 sccm erreicht hat, wird der Ar Fluss auf einen Wert von 50 sccm reduziert.

Die Tabelle zeigt die Parameter des Beispieles im Überblick:

| | |
|---|---|
| Fluss Argon | 50 sccm |
| Fluss Acetylen | 350 sccm |
| Anregungsstrom obere Spule | 10 A |
| Anregungsstrom untere Spule | 3 A |
| Spannungsamplitude | 2400 V |
| Anregungsfrequenz f | 40 kHz |

Bei diesen Verhältnissen ist eine hohe Abscheiderate gewährleistet und die Ionisierung des Plasmas wird mit Hilfe des Ar-Gases aufrechterhalten. Die Abscheiderate die sich nun im Beschichtungsprozess einstellt, wird sich im Bereich zwischen 0.5 und 4 $\mu$m/h belaufen, was auch von der zu beschichtenden Fläche in der Prozesskammer abhängt.

Nach Ablauf der Beschichtungszeit wird der Sinus-Generator und der Gasfluss abgestellt, und die Substrate der Prozesskammer entnommen.

Die Eigenschaften der entstehenden Schicht sind der folgenden Tabelle zu entnehmen

| Eigenschaften Beispiel 1 | |
|---|---|
| Mikrohärte | ca. 2200 HK |
| Abscheiderate | 1-2 $\mu$m/h |
| Haftung | HF1 |
| Widerstand | <10 k$\Omega$ |
| Wasserstoffgehalt | 12% |
| Reibkoeffizient | 0.2 |
| Innere Spannung | ca. 2 GPa |
| Bruchverhalten | Nicht glasig |

**Prozessbeispiel 2**

Prozessbeispiel 2 sieht eine Durchführung ähnlich Beispiel 1 vor. Im Unterschied zu Beispiel 1 wird das Plasma von einem Pulsgenerator erzeugt. Die Anregungsfrequenz liegt bei 50 kHz mit einer Amplituden-Spannung von 700V.

Die Tabelle zeigt die Parameter des 2. Beispiels.

| | |
|---|---|
| Fluss Argon | 50 sccm |
| Fluss Acetylen | 350 sccm |
| Anregungsstrom obere Spule | 10 A |
| Anregungsstrom untere Spule | 3 A |
| Spannungsamplitude | 700 V |
| Anregungsfrequenz f | 40 kHz |

Die erzeugte Beschichtung weist eine Härte von 25 GPa, eine Haftfestigkeit von HF1 auf und ergibt einen Reibbeiwert von 0.2.

| Eigenschaften Beispiel 2 | |
|---|---|
| HK | ca. 2400 |
| Abscheiderate | ca. 1.5 $\mu$m/h |
| Haftung | HF1 |
| Widerstand | >500k$\Omega$ |
| Wasserstoffgehalt | 13% |
| Reibkoeffizient | 0.2 |
| Innere Spannung | Ca. 3 GPa |

**Prozessbeispiel 3**

Prozessbeispiel 3 sieht eine Durchführung ähnlich Beispiel 1 vor. Im Unterschied zu Beispiel 1 wird das Plasma von einer uni-polaren Pulsspannung angeregt, die Parameter des Versuchs zeigt folgende Tabelle.

| Fluss Argon | 50 sccm |
|---|---|
| Fluss Acetylen | 350 sccm |
| Anregungsstrom obere Spule | 10 A |
| Anregungsstrom untere Spule | 3 A |
| Spannungsamplitude | 1150 V |
| Anregungsfrequenz f | 30 kHz |

Die erzeugte Beschichtung weist die in der folgenden Tabelle beschriebene Eigenschaften auf.

| Eigenschaften Beispiel 3 | |
|---|---|
| Mikrohärte | > 2500 HK |
| Abscheiderate | ca. 1.8 $\mu$m/h |
| Haftung | HF1 |
| Widerstand | > 1 k$\Omega$ |
| Wasserstoffgehalt | 12-16% |
| Reibkoeffizient | 0.2 |
| Innere Spannung | ca. 2 GPa |

**Prozessbeispiel 4**

In Vergleich zu Prozessbeispiel 1 wurde im Beispiel 4 ein Prozess ohne Unterstützung durch ein longitudinales Magnetfeld durchgeführt. Der die beiden Spulen durchfliessende Strom wurde auf einen Wert von 0 A reduziert. Die Tabelle zeigt die Prozessparameter.

| Fluss Argon | 50 sccm |
|---|---|
| Fluss Acetylen | 350 sccm |
| Anregungsstrom obere Spule | 0 A |
| Anregungsstrom untere Spule | 0 A |

(fortgesetzt)

| Spannungsamplitude | 2400 V |
|---|---|
| Anregungsfrequenz f | 40 kHz |

Es stellt sich ein Plasma ein, das gegenüber Beispiel 1 erst bei höheren Drücken als bei Beispiel 1 stabil ist, inhomogen über die Prozesskammer verteilt ist und von geometrischen Effekten sehr stark beeinflusst ist. Deshalb kommt es zu einer in der Prozesskammer inhomogenen und wegen der bei dem eingestellten Prozessdruck gegenüber Beispiel 1 geringeren Abscheiderate. Bei den angestrebten Prozessdrücken war eine Plasmabildung ohne den Einsatz einer zweiten Plasmaquelle wie z.B. einem Target oder dem Zuschalten des Filamentes nicht möglich. Erst durch den Einsatz der Helmholtzspulen konnte das Plasma in der Prozesskammer stabilisiert werden und eine homogene Abscheidung über die Höhe der Prozesskammer erreicht werden. Ohne den Einsatz der Spulen zündete ein Plasma im Bereich der Ionisationskammer, wo lokal hohe Temperaturen erzeugt werden und Zerstörung befürchtet werden muss.

| Eigenschaften Beispiel 4 | |
|---|---|
| HK | Inhomogen 1200 - 2500 |
| Abscheiderate | Inhomogen |
| Haftung | Nicht bestimmbar |
| Widerstand | Inhomogen |

**Gleitschichtsysteme**

Im Folgenden wurden auf die wie oben beschriebene DLC-Schichten unterschiedliche Gleitschichten aufgebracht, um ein Schichtsystem herzustellen. Dabei ist darauf zu achten, dass der alle Plasmavorbehandlungen und Beschichtungsschritte enthaltende Prozess durchgehend ohne Unterbrechung des Vakuums gefahren wird, um eine optimale Schichthaftung zu erreichen.

Tabelle 5

| zeigt verschiedene Prozessbeispiele mit einer jeweils graphitisierten Gleitschicht: | | | |
|---|---|---|---|
| **Prozessbeispiel** | **5** | **6** | **7** |
| DLC-Schichtsystem Beispiel | wie 1 aber Spannungsampl. 1000V | 2 | 3 |
| Fluss Argon | 50 sccm | 50 sccm | 50 sccm |
| Fluss Acetylen | 350 sccm | 350 sccm | 350 sccm |
| Anregungsstrom obere Spule | 10 A | 10 A | 10 A |
| Anregungsstrom untere Spule | 3 A | 3 A | 3 A |
| Substrat-Spannungsamplitude | 2400 V | 2400 V | 2400 V |
| Rampe Spannung | 15 min | 25 min | 15 min |
| Anregungsfrequenz f | 40 kHz | 40 kHz | 30 kHz |
| Anregungstyp | AC-Sinus | bipolarer Puls | unipolarer Puls |

Tabelle 6

| zeigt verschiedene Möglichkeiten zur Ausbildung einer Gleitschichten wie z.B. eine abschliessenden Gradientenschicht (Nr.8), einer inversen Gradientenschicht (Nr.9), bzw. einer wasserstofffreichen C-Schicht (Nr.10): | | | |
|---|---|---|---|
| Prozessbeispiel | 8* | 9 | 10 |
| DLC-Schicht Nr. | 3 | 2 | 2 |

(fortgesetzt)

| zeig verschiedene Möglichkeiten zur Ausbildung einer Gleitschichten wie z.B. eine abschliessenden Gradientenschicht (Nr.8), einer inversen Gradientenschicht (Nr.9), bzw. einer wasserstoffreichen C-Schicht (Nr.10): | | | |
|---|---|---|---|
| Prozessbeispiel | 8* | 9 | 10 |
| Fluss Argon 1 | 30 sccm | 50 sccm | 50 sccm |
| Fluss Argon 2 | 30 (100) sccm | - | - |
| Rampe Argon | 0 (10)min | - | - |
| Fluss Acetylen 1 | 0 sccm | 350 sccm | 350 sccm |
| Fluss Acetylen 2 | 250 sccm | 180 sccm | 150 sccm |
| Rampe Acetylen | 15 min | 20 min | 20 min |
| Fluss Methan 1 | - | - | 0 sccm |
| Fluss Methan 2 | - | - | 150 sccm |
| Rampe Methan | - | - | 20 min |
| Leistung Cr-Target 1 | 8 kW | 7 kW | - |
| Leistung Cr-Target 2 | 7 kW | - | - |
| Rampe Cr-Target | 20 min | 30 min | - |
| Anregungsstrom obere Spule | 10 A | 10 A | 10 A |
| Anregungsstrom untere Spule | 3 A | 3 A | 3 A |
| Substrat-Spannungsamplitude | 2400 V | 700 V | 1150 V |
| Anregungsfrequenz f | 40 kHz | 40 kHz | 30 kHz |
| Anregungstyp | AC-Sinus | bipolarer Puls | unipolarer Puls |

Die Acetylenrampe kann hierbei auch mit einer zeilichen Verzögerung von 5-10 min nach Einschalten der Cr-Targets gestartet werden. Ein solches Vorgehen ist besonders vorteilhaft, wenn DLC- und Gleitschicht in unterschiedlichen Prozesskammern oder Beschichtungsanlagen aufgebracht werden. Dabei kann auch an Stelle des Sinusgenerators eine Gleichspannungsquelle zum Anlegen des Suabstratbias verwendet werden.

Weiters kann der Graphitanteil durch gleichzeitiges oder ebenfalls verzögert eingeschaltetes Co-Sputtern von karbidischen beispielsweise WC- und/oder Graphittargets erhöht werden. Will man die besonders günstigen Gleiteigenschaften von W- bzw. Ta oder Nb / C-Schichten nutzen, ist es vorteilhaft die Cr-Targets nach Ausbildung einer Haft-bzw. Gradientenschicht abzuschalten, bzw. herunterzuregeln und den Prozess nur mit den entsprechenden Metall- bzw. Metallkarbidtargets zu Ende zu fahren.

Die Eigenschaften der entsprechenden DLC-Schichten sind **Tabelle 8** und

| VersuchNr. | **5** | **6** | **7** |
|---|---|---|---|
| Haftung | HF 1 | HF 1 | HF 1 |
| Widerstand | < 100 kΩ | < 100 kΩ | < 100 kΩ |
| Reibkoeffizient | ca. 0.10 | ca. 0.15 | ca. 0.12 |

**Tabelle 9** zu entnehmen:

| VersuchNr. | **8** | **9** | **10** |
|---|---|---|---|
| Haftung | HF 1 | HF 1 | HF 1 |
| Widerstand | < 1 kΩ | < 1 kΩ | < 100 kΩ |
| Wasserstoffgehalt | n.g. | n.g. | > 30 atom% |

(fortgesetzt)

| VersuchNr. | 8 | 9 | 10 |
|---|---|---|---|
| Reibkoeffizient | ca. 0.08 | ca. 0.07 | ca. 0.13 |

**Bezugszeichenliste**

1. Prozesskammer
2. zu beschichtende Teile
3. Halterungsvorrichtung
4. einfache Rotation
5. zweifache Rotation
6. Anlagenachse
7. Karussell
8. Gaseinlass
9. Pumpstand
10. Ionenquelle
11. Gleichspannungsversorgung
12. Schalter
13. Hilfsanode
14. Verdampferquelle
15. Niedervoltbogen
16. Spannungsversorgung
17. elektromagnetische Spule
18. MF-Plasma
19. Seitenwand
20. Magnetsysteme
21. Nahfelder
22. Magnetronmagnetsysteme

**Patentansprüche**

**1.** Verfahren zur Herstellung eines Schichtsystems auf einem Substrat, **dadurch gekennzeichnet, dass** das Verfahren umfasst:

a) Einbringen des Substrates in eine Vakuumkammer und Abpumpen bis ein Vakuum mit einem Druck von weniger als $10^{-4}$ mbar, vorzugweise $10^{-5}$ mbar erreicht ist.
b) Reinigen der Substratoberfläche
c) plasmagestütztes Aufdampfen der Haftschicht auf das Substrat
d) Aufbringen der Übergangsschicht auf die Haftschicht durch gleichzeitiges plasmagestütztes Aufdampfen der Haftschichtkomponenten und Abscheiden von Kohlenstoff aus der Gasphase
e) Aufbringen der diamantähnlichen Kohlenstoffschicht auf die Übergangsschicht durch plasmagestütztes Abscheiden von Kohlenstoff aus der Gasphase,

wobei die die Deckschicht bildende diamantähnliche Kohlenstoffschicht durch Plasma-CVD-Abscheidung von Kohlenstoff aus der Gasphase erzeugt wird, wobei als Reaktionsgas ein kohlenstoffhaltiges Gas, vorzugsweise ein Kohlenwasserstoffgas, insbesondere Acetylen verwendet wird, wobei zumindest während der Verfahrensschritte c), d) und e) am Substrat eine unipolare oder bipolare Substratbiasspannung angelegt wird, die in einem Mittelfrequenzbereich von 1 bis 10.000 kHz, vorzugsweise 20 bis 250 kHz, gepulst ist, und zumindest während der Verfahrensschritte d) und e) das Plasma durch ein Magnetfeld stabilisiert wird, wobei während des Aufbringens der Übergangsschicht und der Deckschicht aus diamantähnlichen Kohlenstoff dem Substrat ein longitudinales Magnetfeld mit gleichmäßigem Feldlinienverlauf überlagert wird, wobei das Magnetfeld räumlich kontinuierlich oder schrittweise veränderbar ist.

2. Verfahren nach Merkmalssatz 1, **dadurch gekennzeichnet, dass** das Reinigen der Substratoberfläche einen Heizschritt und/oder Ätzschritt umfasst.

3. Verfahren nach Merkmalssatz 2, **dadurch gekennzeichnet, dass** der Heizschritt durch Strahlungsheizen, induktives Heizen und/oder durch Elektronenbeschuss erfolgt.

4. Verfahren nach Merkmalssatz 3, **dadurch gekennzeichnet, dass** der Elektronenbeschuss durch das Zünden eines Niedervoltbogens und das gleichzeitige Anlegen einer kontinuierlichen, einer AC- oder AC überlagerten Biasspannung, wie insbesondere einer gepulsten positiven Substratbiasspannung bewirkt wird.

5. Verfahren nach Merkmalssatz 2, **dadurch gekennzeichnet, dass** der Ätzschritt durch Ionenätzen durchgeführt wird, wobei mit einem Edelgas, vorzugsweise Argon, und/oder Wasserstoff als Prozessgas eine Niedervoltlichtbogen gezündet wird und an das Substrat eine kontinuierliche Substratbiasspannung angelegt wird.

6. Verfahren nach Merkmalssatz 2, **dadurch gekennzeichnet, dass** der Ätzschritt durch Ionenätzen mit einem Edelgas vorzugsweise Argon, und/oder Wasserstoff als Prozessgas durchgeführt wird, wobei eine AC- oder AC überlagerte Biasspannung, wie insbesondere eine gepulste, vorzugsweise mittelfrequente Substratbiasspannung angelegt wird.

7. Verfahren nach einem der Merkmalssätze 1 bis 6, **dadurch gekennzeichnet, dass** das Aufdampfen der Haftschicht durch Plasma-CVD-Verfahren, PVD-Verfahren, insbesondere Arcverdampfung, katodisches Sputtern, Verdampfen aus einem Tiegel mittels Niedervoltbogen, bevorzugt mittels einem Ionplatingverfahren erfolgt.

8. Verfahren nach Merkmalssatz 7, **dadurch gekennzeichnet, dass** das Aufdampfen der Haftschicht durch eine zusätzliche Niedervoltlichtbogenentladung unterstützt wird und an das Substrat eine negative Substratbiasspannung angelegt wird.

9. Verfahren nach Merkmalssatz 7, **dadurch gekennzeichnet, dass** das Aufdampfen der Haftschicht durch eine zusätzliche gepulste Substratbiasspannung, wobei eine AC- oder AC überlagerte Biasspannung, wie insbesondere eine gepulste Substratbiasspannung in einem Mittelfrequenzbereich von 1 bis 20.000 kHz, vorzugsweise 20 bis 250 kHz unterstützt wird.

10. Verfahren nach einem der Merkmalssätze 1 bis 9, **dadurch gekennzeichnet, dass** für das Zünden eines Plasmas ein Edelgas oder ein Edelgas/Wasserstoff-Gemisch, vorzugsweise Argon/Wasserstoff-Gemisch in die Vakuumkammer eingebracht wird.

11. Verfahren nach einem der Merkmalssätze 1 bis 10, **dadurch gekennzeichnet, dass** die Übergangsschicht durch zeitgleiches Aufdampfen von mindestens einem Element aus der Gruppe, die die Elemente der 4., 5. und 6. Nebengruppe und Silizium enthält, nach einem Verfahren gemäss einem der Ansprüche 7 bis 10 und plasmagestütztes Abscheiden von Kohlenstoff aus der Gasphase gebildet wird, wobei zusätzlich als Reaktionsgas ein kohlenstoffhaltiges Gas, vorzugsweise ein Kohlenwasserstoffgas, insbesondere Acetylen verwendet wird.

12. Verfahren nach Merkmalssatz 1, **dadurch gekennzeichnet, dass** mit zunehmender Dicke der Übergangsschicht der Anteil der Kohlenstoffabscheidung schrittweise oder kontinuierlich erhöht wird.

13. Verfahren nach einem der Merkmalssätze 2 bis 12, **dadurch gekennzeichnet, dass** das Reaktionsgas zur Abscheidung von Kohlenstoff neben dem kohlenstoffhaltigen Gas Wasserstoff und/oder Edelgas, vorzugsweise Argon oder/und Xenon umfasst.

14. Verfahren nach Merkmalssatz 13, **dadurch gekennzeichnet, dass** während des Abscheidens der Deckschicht aus diamantähnlichem Kohlenstoff der Anteil des kohlenstoffhaltigen Gases erhöht und/oder der Anteil des Edelgases, insbesondere Argon, gesenkt wird.

15. Verfahren nach Merkmalssatz 1, **dadurch gekennzeichnet, dass** die Substratbiasspannung sinusförmig oder derart gepulst ist, dass lange negative und kurze positive Impulszeiten oder große negative und geringe positive Amplituden angelegt werden.

16. Verfahren nach einem der Merkmalssätze 1 bis 15, **dadurch gekennzeichnet, dass** während des Reinigen und/oder des Aufbringens der Haftschicht dem Substrat ein longitudinales Magnetfeld mit gleichmäßigem Feldlinienverlauf überlagert wird, wobei das Magnetfeld zeitlich und/oder räumlich kontinuierlich oder schrittweise veränderbar ist.

17. Verfahren nach einem der Merkmalssätze 1 bis 16, **dadurch gekennzeichnet, dass** das Aufbringen der Haftschicht und/oder Übergangsschicht und/oder Deckschicht aus diamantähnlichem Kohlenstoff unter einem Druck von $10^{-4}$ mbar bis $10^{-2}$ mbar erfolgt.

**Claims**

1. Method for producing a layer system on a substrate, **characterised in that** the method comprises:

   a) introducing the substrate into a vacuum chamber and pumping out until a vacuum with a pressure of less than $10^{-4}$ mbar, preferably $10^{-5}$ mbar, has been reached.
   b) cleaning the substrate surface
   c) plasma-supported vapour deposition of the adhesive layer onto the substrate
   d) application of the transition layer on the adhesive layer by simultaneous plasma-supported vapour deposition of the adhesive layer components and deposition of carbon from the gas phase,
   e) application of the diamond-like carbon layer onto the transition layer by plasma-supported deposition of carbon from the gas phase,

   wherein the diamond-like carbon layer constituting the cover layer is produced by plasma-CVD deposition of carbon from the gas phase, wherein a carbon-containing gas, preferably a hydrocarbon gas, in particular acetylene, is used as the reaction gas, wherein at least during method steps c), d) and e) a unipolar or bipolar substrate bias voltage is applied to the substrate, which voltage is pulsed in a mean frequency range of 1 to 10,000 kHz, preferably 20 to 250 kHz, and the plasma is stabilised by a magnetic field at least during method steps d) and e), wherein during the application of the transition layer and of the cover layer of diamond-like carbon, a longitudinal magnetic field with a uniform field line shape is superimposed on the substrate, wherein the magnetic field is continuously or incrementally alterable spatially.

2. Method according to claim 1, **characterised in that** the cleaning of the substrate surface comprises a heating step and/or etching step.

3. Method according to claim 2, **characterised in that** the heating step is effected by radiant heating, inductive heating and/or by electron bombardment.

4. Method according to claim 3, **characterised in that** the electron bombardment is caused by the ignition of a low-voltage arc and the simultaneous application of a continuous AC or AC superimposed bias voltage, in particular such as a pulsed, positive substrate bias voltage.

5. Method according to claim 2, **characterised in that** the etching step is performed by ion etching, wherein a low-voltage arc is ignited with a noble gas, preferably argon, and/or hydrogen as a process gas and a continuous substrate bias voltage is applied to the substrate.

6. Method according to claim 2, **characterised in that** the etching step is performed by means of ion etching with a noble gas, preferably argon, and/or hydrogen as a process gas, wherein an AC or AC superimposed bias voltage, in particular such as a pulsed, preferably mean frequency, substrate bias voltage is applied.

7. Method according to any one of claims 1 to 6, **characterised in that** the vapour deposition of the adhesive layer is effected by plasma-CVD methods, PVD methods, in particular arc vaporisation, cathodic sputtering, vaporisation from a crucible by means of low-voltage arcs, preferably by means of an ion plating method.

8. Method according to claim 7, **characterised in that** the vapour deposition of the adhesive layer is supported by an additional low-voltage arc discharge and a negative substrate bias voltage is applied to the substrate.

9. Method according to claim 7, **characterised in that** the vapour deposition of the adhesive layer is supported by an additional pulsed substrate bias voltage, an AC or AC superimposed bias voltage, in particular such as a pulsed substrate bias voltage in a mean frequency range from 1 to 20,000 kHz, preferably 20 to 250 kHz.

**10.** Method according to any one of claims 1 to 9, **characterised in that** a noble gas or a noble gas/hydrogen mixture, preferably an argon/hydrogen mixture, is introduced into the vacuum chamber for the ignition of a plasma.

**11.** Method according to any one of claims 1 to 10, **characterised in that** the transition layer is formed by simultaneous vapour deposition of at least one element from the group containing the elements of the 4th, 5th and 6th sub-group and silicon, in accordance with a method according to one of claims 7 to 10 and plasma-supported deposition of carbon from the gas phase, wherein a carbon-containing gas, preferably a hydrocarbon gas, in particular acetylene, is used as a reaction gas.

**12.** Method according to claim 1, **characterised in that** the proportion of the carbon deposition is increased incrementally or continuously with an increasing thickness of the transition layer.

**13.** Method according to any one of claims 2 to 12, **characterised in that** the reaction gas for depositing carbon comprises hydrogen and/or noble gas, preferably argon and/or xenon, in addition to the carbon-containing gas.

**14.** Method according to claim 13, **characterised in that** during the deposition of the cover layer of diamond-like carbon, the proportion of the carbon-containing gas is increased and/or the proportion of the noble gas, in particular argon, is reduced.

**15.** Method according to claim 1, **characterised in that** the substrate bias voltage is pulsed sinusoidally or such that long negative and short positive pulse times or large negative and small positive amplitudes are applied.

**16.** Method according to any one of claims 1 to 15, **characterised in that** during the cleaning and/or the application of the adhesive layer, a longitudinal magnetic field with a uniform field line shape is superimposed on the substrate, wherein the magnetic field is continuously or incrementally alterable temporally and/or spatially.

**17.** Method according to any one of claims 1 to 16, **characterised in that** the application of the adhesive layer and/or transition layer and/or cover layer of diamond-like carbon is effected under a pressure of $10^{-4}$ mbar to $10^{-2}$ mbar.

## Revendications

**1.** Procédé de fabrication d'un système de couches sur un substrat, **caractérisé en ce que** le procédé comprend :

a) la pose du substrat dans une chambre à vide et vidage à la pompe jusqu'à obtention d'un vide ayant une pression inférieure à $10^{-4}$ mbar, de préférence $10^{-5}$ mbar,
b) le nettoyage de la surface du substrat
c) la métallisation sous vide par plasma de la couche adhésive sur le substrat
d) l'application de la couche de transition sur la couche adhésive par, simultanément, métallisation sous vide par plasma des composants de la couche adhésive et extraction du carbone hors de la phase gazeuse
e) l'application de la couche de carbone similaire au diamant sur la couche de transition par extraction, assistée par plasma, du carbone hors de la phase gazeuse,

la couche de carbone similaire au diamant formant la couche de couverture étant produite par dépôt chimique en phase vapeur assisté par plasma du carbone hors de la phase gazeuse, un gaz contenant du carbone, de préférence un hydrocarbure à l'état gazeux, en particulier de l'acétylène, étant utilisé en tant que gaz de réaction, dans lequel, au moins pendant les étapes de procédé c), d) et e), une tension de polarisation de substrat unipolaire ou bipolaire est appliquée au substrat, laquelle oscille avec une fréquence moyenne de 1 à 10 000 kHz, de préférence 20 à 250 kHz, et au moins pendant les étapes de procédé d) et e), le plasma est stabilisé par un champ magnétique, dans lequel, pendant l'application de la couche de transition et de la couche de couverture en carbone similaire au diamant, un champ magnétique longitudinal avec tracé de ligne de champ constant est superposé au substrat, le champ magnétique étant modifiable spatialement continuellement ou par paliers.

**2.** Procédé selon la revendication 1, **caractérisé en ce que** le nettoyage de la surface de substrat comprend une étape de chauffage et/ou une étape de gravure.

**3.** Procédé selon la revendication 2, **caractérisé en ce que** l'étape de chauffage est réalisée par chauffage par rayonnement, chauffage par induction et/ou par bombardement électronique.

**4.** Procédé selon la revendication 3, **caractérisé en ce que** le bombardement électronique est provoqué par l'allumage d'un arc électrique basse tension et l'application simultanée d'une tension de polarisation continue, alternative ou alternative superposée, telle que en particulier une tension de polarisation de substrat positive oscillante.

**5.** Procédé selon la revendication 2, **caractérisé en ce que** l'étape de gravure est réalisée par gravure ionique, un arc électrique basse tension étant allumé avec un gaz rare, de préférence de l'argon, et/ou de l'hydrogène en tant que gaz de process, et une tension de polarisation de substrat continue étant appliquée au substrat.

**6.** Procédé selon la revendication 2, **caractérisé en ce que** l'étape de gravure est réalisée par gravure ionique avec un gaz rare, de préférence de l'argon, et/ou de l'hydrogène en tant que gaz de process, une tension de polarisation alternative ou alternative superposée, telle que en particulier une tension de polarisation de substrat oscillante de préférence de moyenne fréquence, étant appliquée.

**7.** Procédé selon une des revendications 1 à 6, **caractérisé en ce que** la métallisation sous vide de la couche adhésive a lieu par procédé de dépôt chimique en phase vapeur (CVD) assisté par plasma, par procédé de dépôt physique en phase vapeur (PVD), en particulier évaporation à l'arc, pulvérisation cathodique, évaporation depuis un creuset au moyen de l'arc basse tension, de préférence au moyen d'un procédé de placage ionique.

**8.** Procédé selon la revendication 7, **caractérisé en ce que** la métallisation sous vide de la couche adhésive est réalisée avec une décharge d'arc électrique basse tension supplémentaire, et **en ce qu'**une tension de polarisation de substrat négative est appliquée au substrat.

**9.** Procédé selon la revendication 7, **caractérisé en ce que** la métallisation sous vide de la couche adhésive est réalisée avec une tension de polarisation de substrat oscillante supplémentaire, en sorte qu'une tension de polarisation alternative ou alternative superposée est appliquée, telle que en particulier une tension de polarisation de substrat oscillante avec une fréquence moyenne de 1 à 20 000 kHz, de préférence de 20 à 250 kHz.

**10.** Procédé selon une des revendications 1 à 9, **caractérisé en ce que** pour l'allumage d'un plasma, un gaz rare ou un mélange de gaz rare et d'hydrogène, de préférence un mélange d'argon et d'hydrogène, est introduit dans la chambre à vide.

**11.** Procédé selon une des revendications 1 à 10, **caractérisé en ce que** la couche de transition est formée par, simultanément, métallisation sous vide d'au moins un élément du groupe contenant les éléments des groupes IV, V et VI et le silicium, selon un procédé selon une des revendications 7 à 10 et extraction assistée par plasma du carbone hors de la phase gazeuse, un gaz contenant du carbone, de préférence un hydrocarbure à l'état gazeux, en particulier de l'acétylène, étant utilisé comme gaz de réaction supplémentaire.

**12.** Procédé selon la revendication 1, **caractérisé en ce que,** avec l'épaisseur croissante de la couche de transition, la part d'extraction de carbone est augmentée par paliers ou de manière continue.

**13.** Procédé selon une des revendications 2 à 12, **caractérisé en ce que** le gaz de réaction comprend pour l'extraction du carbone, en plus du gaz contenant du carbone, de l'hydrogène et/ou du gaz rare, de préférence de l'argon ou/et du xénon.

**14.** Procédé selon la revendication 13, **caractérisé en ce que** pendant la séparation de la couche de couverture en carbone similaire au diamant, la part de gaz contenant du carbone augmente et/ou la part de gaz rare, en particulier de l'argon, diminue.

**15.** Procédé selon la revendication 1, **caractérisé en ce que** la tension de polarisation de substrat est sinusoïdale, ou oscille de telle manière que des temps d'impulsion négatifs longs ou positifs courts ou de grandes amplitudes négatives et de faibles amplitudes positives sont appliqués.

**16.** Procédé selon une des revendications 1 à 15, **caractérisé en ce que** pendant le nettoyage et/ou l'application de la couche adhésive, un champ magnétique longitudinal avec tracé de ligne de champ constant est superposé au substrat, le champ magnétique étant modifiable dans le temps et/ou spatialement continuellement ou par paliers.

**17.** Procédé selon une des revendications 1 à 16, **caractérisé en ce que** l'application de la couche adhésive et/ou de la couche de transition et/ou de la couche de couverture en carbone similaire au diamant a lieu à une pression de

$10^{-4}$ mbar à $10^{-2}$ mbar.

Figure 1

Figure 2

Figure 3

# Figure 4

Parameter

C$_2$H$_{2\text{-Fluss}}$ 200 - 400sccm

500 bis 2500V Pulsspannung

Ar-Fluss 100-200 sccm

Leistung Cr-Targets 8kW

7kW

50sccm

5kW

0-100 sccm

6  8  11                21  23        33        38

Time (min)

EP 1 362 931 B2

# Figure 5

## Figure 6

Querbruchaufnahme einer erfindungsgemäss hergestellten Schicht.

# Figure 7

## Prozess - Gesamtverlauf ohne Gleitschicht

Parameter

$C_2H_{2\text{-Fluss}}$ 200 - 400sccm

500 bis 2500V Pulsspannung

Ar-Fluss 100-200 sccm

Leistung Cr-Targets 8kW

7kW

50sccm

0-100 sccm

6  8  11        21  23    33    38                    98

Time (min)

EP 1 362 931 B2

# Figure 8

**Parameter**

## Graphitisierte Gleitschicht

$C_2H_{2\text{-Fluss}}$ 200 - 400sccm

1500 bis 2500V Pulsspannung

Ar-Fluss 100-200 sccm

500 bis 1200V Pulsspannung

Leistung Cr-Targets
8kW

7kW

50sccm

0-100 sccm

6  8  11        21        33-60

Time (min)

EP 1 362 931 B2

Figure 9

Inverse gradient layer

Figure 10

Gradientenschicht

# Figure 11

Parameter

H2 - rich - layer

C$_2$H$_{2\text{-Fluss}}$ 200 - 400sccm

1500 bis 2500V Pulsspannung

CH$_4$-Fluss 40-200 sccm

Ar-Fluss 100-200 sccm

C$_2$H$_{2\text{-Fluss}}$ 50 - 250sccm

Leistung Cr-Targets 8kW

7kW

50sccm

5kW

0-100 sccm

6    8    11              21        33-60

Time (min)

EP 1 362 931 B2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 87836 A
- DE 4343354 A1
- US 5078848 A
- EP 651069 A
- EP 600533 A
- EP 885983 A
- EP 856592 A

- US 4728529 A
- DE 19513614 C
- DE 19826259 A
- US 5707748 A
- WO 9955929 A
- FR 2596775
- US 5709784 A

**In der Beschreibung aufgeführte Nicht-Patentliteratur**

- DLC multilayer coatings for wear protection. **DENG J. et al.** Diamond and Related Materials. Elsevier Science Publishers, 15. Mai 1995, vol. 4, 936-943